(19) Europäisches Patentamt
European Patent Office
Office européen des brevets

(11) EP 2 743 081 A1

(12) **EUROPEAN PATENT APPLICATION**
published in accordance with Art. 153(4) EPC

(43) Date of publication:
18.06.2014 Bulletin 2014/25

(51) Int Cl.:
**B32B 27/32** (2006.01)

(21) Application number: **12821662.9**

(22) Date of filing: **31.07.2012**

(86) International application number:
**PCT/JP2012/069440**

(87) International publication number:
**WO 2013/021860 (14.02.2013 Gazette 2013/07)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **11.08.2011 JP 2011175662**

(71) Applicant: **Toray Industries, Inc.**
**Tokyo 103-8666 (JP)**

(72) Inventors:
• **SHIMAZU, Ayako**
**Shiga 5208558 (JP)**

• **SHIOMI, Atsushi**
**Shiga 5208558 (JP)**
• **AOYAMA, Shigeru**
**Shiga 5208558 (JP)**
• **TAKAHASHI, Kozo**
**Shiga 5208558 (JP)**

(74) Representative: **Prüfer & Partner GbR**
**European Patent Attorneys**
**Sohnckestrasse 12**
**81479 München (DE)**

(54) **LAMINATED SHEET AND METHOD FOR PRODUCING SAME**

(57) With respect to a sheet in which an olefin resin is laminated on one surface layer of a PET film by melt extrusion lamination, a conventional melt extrusion lamination method has drawbacks that, because the PET film and the olefin resin are different in terms of a heat-shrinkable property and a crystalline property, they are extremely curled when laminated, handling becomes very difficult, and the secondary workability is poor. In view of the conventional drawbacks, the present invention provides a backsheet for a solar cell which has favorable long-term durability, curling property, inter-layer adhesion property, partial discharge voltage, and workability. Provided is a laminated sheet formed by laminating at least a layer (P1 layer) mainly composed of a polyester resin, an adhesive resin layer (P2 layer), and a layer (P3 layer) mainly composed of a polyolefin resin, in this order, with the total thickness of the laminated sheet being 30 to 50 $\mu$m, the thickness of the P2 layer being 0.1 to 3 $\mu$m, and the ratio of the thicknesses of the P1 layer and P3 layer (P1/P3) being 0.2 to 5.

Figure 1

EP 2 743 081 A1

**Description**

[Technical Field]

This invention relates to a laminate sheet having a favorable long term durability, anti-curling property, interlayer adhesion, partial discharge voltage, and processibility. More specifically, this invention relates to a laminate sheet which can be used for a backsheet of solar cell and a method for producing such laminate sheet.

[Background Art]

Recently, photovoltaic power generation is gaining spotlight as a semipermanent and non-polluting next generation energy source, and solar cells are rapidly finding wide use. A solar cell comprises a photovoltaic element sealed in a transparent sealant such as ethylene - vinyl acetate copolymer (EVA), and a transparent substrate such as glass substrate and a resin sheet called a backsheet are adhered to the sealant. The sunlight is introduced in the solar cell through the transparent substrate 4. The sun light introduced is then absorbed by the photovoltaic element, and the absorbed light energy is converted to the electric energy. The converted electric energy is taken out of the photovoltaic element by the lead connected to the photovoltaic element, and the electric energy is used in various electric appliances. Conventional backsheet 1 was constituted from an inexpensive high performance biaxially stretched polyethylene terephthalate (PET) laminated with various materials by dry lamination, and the backsheet of various constitutions have been proposed for providing barrier property and electric property. More specifically, use of an olefin resin has been a common practice for the backsheet because of the good barrier property and good adhesion with the sealant.

In the meanwhile, melt extrusion lamination has been investigated in order to improve the productivity of the backsheet by omitting the step of dry lamination. The constitution comprising a biaxially stretched PET thin film having an olefin resin disposed on opposite surfaces (Patent Document 1) and the constitution comprising an olefin resin having PET disposed on opposite surfaces (Patent Document 2) have been proposed.

[Prior Art Literature]

[Patent Literature]

[Patent Document 1] Japanese Patent No. 4217935
[Patent Document 2] Japanese Patent Application Laid-Open No. 2009-267294

[Summary of Invention]

[Problems to be solved by the invention]

However, the thin PET film having an olefin resin layer disposed on opposite surfaces of the film had the drawback of low flame retardancy, and also, self supporting property was insufficient and this resulted in the risk of warping in the secondary processing. The olefin resin film having a PET film disposed on opposite surfaces of the film had the drawback of insufficient adhesion with the sealant, and long term durability was also insufficient.

In order to solve the problems as described above, the inventors of the present invention developed a sheet having an olefin resin layer formed on one surface of a PET film by melt extrusion lamination. This was an improvement from the product prepared by conventional melt extrusion lamination, which had the problem of strong curling upon lamination due to the difference in thermal contraction property and crystallinity between the PET film and the olefin, which resulted in the extremely difficult handling and poor secondary processibility. Furthermore, in using such laminate sheet for the solar cell backsheet, a highly durable PET film had to be selectively used for the PET layer, while such highly durable PET film generally suffered from poor adhesion with other materials compared to universal PET film due to the extremely low content of the terminal COOH in the film. In view of such situation of conventional products, the present invention provides a backsheet for a solar cell having good long term durability, anti-curl properties, interlayer adhesion, voltage resistance, and processibility.

[Means for Solving the Problems]

In order to solve the problems as described above, the present invention has the following constitution. That is, the laminate sheet comprises a layer containing a polyester resin as its main component (P1 layer), an adhesive resin layer (P2 layer), and a layer containing a polyolefin resin as its main component (P3 layer), and the laminate sheet has a total thickness of at least 30 μm and up to 500 μm, the P2 layer has a thickness of at least 0.1μ m and up to 3 μm, and ratio of the thickness of the P1 layer (P1) to the thickness of the P3 layer (P3) (ratio P1/P3) is at least 0.2 and up to 5.

[Advantageous Effects of Invention]

The present invention is capable of providing a laminate sheet having improved long term durability, anti-curl properties, interlayer adhesion, partial discharge voltage, and processibility compared to the conventional laminate sheets comprising the polyester resin layer and the olefin resin layer. Such laminate sheet is well adapted for use as a backsheet of a solar cell, and a high performance solar cell can be provided by the use of such backsheet.

[Brief Description of the Drawing]

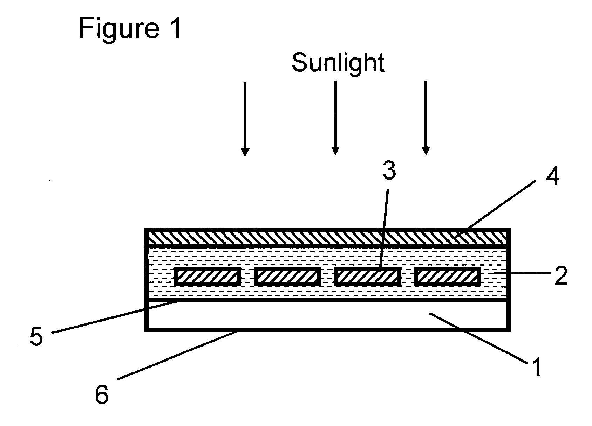

[FIG. 1] FIG. 1 is a schematic cross sectional view showing an exemplary constitution of the solar cell prepared by using the laminate sheet of the present invention.

[Description of Embodiments]

The laminate sheet of the present invention comprises a layer containing a polyester resin as its main component (P1 layer), an adhesive resin layer (P2 layer), and a layer containing a polyolefin resin as its main component (P3 layer). Preferably, the laminate sheet has a total thickness of at least 30 μm and up to 500 μm, and the P2 layer has a thickness of at least 0.1 μm and up to 3 μm. The ratio of the thickness of the P1 layer (P1) to the thickness of the P3 layer (P3) (ratio P1/P3) is at least 0.2 and up to 5.

The laminate sheet of the present invention preferably has a total thickness of at least 30 μm and up to 500 μm. The laminate sheet having the total thickness of less than 30 μm may suffer from the problem of the reduced discharge voltage, and use at a high voltage may invite dielectric breakdown. When the total thickness is more than 500 μm, the laminate sheet will have poor processibility, and when such laminate sheet is used for the solar cell backsheet, the solar cell will have an unduly increased total thickness. More preferably, the total thickness is at least 40 μm, and still more preferably, at least 50 μm, and more preferably, the total thickness is up to 450 μm, and still more preferably up to 400 μm. More specifically, the total thickness is preferably in the range of at least 40 μm and up to 450 μm, and still more preferably, at least 50 μm and up to 400 μm.

When the P1 layer has a thickness of P1 and the P3 layer has a thickness of P3, the thickness ratio P1/P3 of the laminate sheet of the present invention is at least 0.2 and up to 5. When thickness ratio P1/P3 is less than 0.2, the resulting laminate sheet will have a poor anti-curl properties. When the thickness ratio P1/P3 is in excess of 5, the laminate sheet will result in the reduced proportion of the olefin layer, and hence, in the poor gas barrier properties. The thickness ratio P1/P3 is more preferably at least 0.5, and even more preferably at least 0.7. The thickness ratio P1/P3 also more preferably up to 4, and even more preferably up to 3. The preferable range of the thickness ratio P1/P3 is at least 0.5 and up to 4, and more preferable range is at least 0.7 and up to 3. When the thickness ratio P1/P3 is within such range, the problem of curling which has been a serious problem in the conventional lamination by melt extrusion of the polyester film and the polyolefin resin can be obviated. In the case of the laminate constitution of the P1 layer and the P3 layer of the present invention, the curling proceeds with the side of the P3 layer in the inside, and the curling can be reduced by increasing the thickness ratio P1/P3, namely, due to the increase of the sheet rigidity.

The P1 layer in the laminate sheet of the present invention may have a thickness of at least 15 μm and up to 300 μm. When the thickness is less than 15 μm, problems such as unduly increased curling and loss of gas barrier property due to the excessively thin P3 layer are caused and even if the total thickness and the thickness ratio P1/P3 are controlled so that they are within the scope of the invention. When the thickness is in excess of 300 μm, the total thickness of the laminate sheet will also be increased, and if the total thickness is to be reduced, thickness of the olefin layer should be reduced, and this in turn results in the loss of gas barrier property. More preferably, the thickness of the P1 layer is at least 25 μm, and still more preferably at least 30 μm, and the thickness of the P1 is more preferably up to 250 μm, and still more preferably up to 200 μm. More specifically, the preferable range is at least 25 μm and up to 250 μm, and more preferably at least 30 μm and up to 200 μm.

The thickness of the P3 layer in the laminate sheet of the present invention may be a thickness in the range so that the thickness ratio P1/P3 is at least 0.2 and up to 5. However, the thickness is preferably at least 75 μm and up to 400 μm, and more preferably at least 100 μm and up to 300 μm. The thickness of the P3 layer of less than 75 μm may invite loss of the gas barrier property while the thickness in excess of 400 μm may result in the increase of the curling, and accordingly, loss of the processibility.

In the laminate sheet of the present invention, thickness of the P2 layer should be at least 0.1 μm and up to 3 μm. When the thickness of the P2 layer is less than 0.1 μm, interlayer peeling may occur after the formation of the laminate sheet by the loss of adhesion between the P1 layer, the P2 layer, and the P3 layer. When the thickness is in excess of 3 $\mu$m, a longer time is required for the development of the adhesion (promotion of the crosslinking between the main component and the curing agent), and this may result in the poor wet heat resistance of the adhesive layer. More preferably, the thickness of the P2 layer is at least 0.15 $\mu$m, and still more preferably at least 0.2 $\mu$m. The thickness is also preferably up to 2 $\mu$m, and more preferably up to 1 $\mu$m. The thickness is preferably in the range of at least 0.15 $\mu$m and up to 2 $\mu$m, and more preferably at least 0.2 $\mu$m and up to 1 $\mu$m. More specifically, provision of the P2 layer by inline coating during the formation of the P1 layer enables simplification of the production step, formation of a good film, and loss of thickness inconsistency and coating defects.

The P1 layer of the present invention contains a polyester resin as its component. In the following description, the P1 layer may have a laminate structure, and in such case, the entire laminate structure of the P1 layer contains the polyester resin as the main component. The term "main component" used herein means that the polyester resin constitutes more than 50% by weight of the P1 layer. Exemplary polyester resins used in the P1 layer include polyethylene terephthalate, polyethylene-2,6-naphthalate, polypropylene terephthalate, polybuthylene terephthalate, and polylactic acid. The polyolefin resin used in the present invention may be produced by 1) polycondensation of a dicarboxylic acid component or its ester-forming derivative (hereinafter generally referred to as the "dicarboxylic acid component") and a diol component, 2) polycondensation of a compound having carboxylic acid or carboxylic acid derivative moiety and hydroxy group in a molecule, or by the combination of 1) and 2). The polymerization of the polyester resin may be caused by the method commonly used in the art.

Typical dicarboxylic acid components in 1) include aliphatic dicarboxylic acids such as malonic acid, succinic acid, glutaric acid, adipic acid, suberic acid, sebacic acid, dodecanedioic acid, dimer acid, eicosanedioic acid, pimelic acid, azelaic acid, methyl malonic acid, and ethylmalonic acid; alicyclic dicarboxylic acids such as adamantanedicarboxylic acid, norbornenedicarboxylic acid, isosorbide, cyclohexanedicarboxylic acid, and decalindicarboxylic acid; aromatic dicarboxylic acids such as terephthalic acid, isophthalic acid, phthalic acid, 1,4-naphthalene dicarboxylic acid, 1,5-naphthalene dicarboxylic acid, 2,6-naphthalene dicarboxylic acid, 1,8-naphthalene dicarboxylic acid, 4,4'-diphenyl dicarboxylic acid, 4,4'-diphenyl ether dicarboxylic acid, 4,4'-diphenylsulfonedicarboxylic acid, 5-sodium sulfoisophthalic acid, phenyl indane dicarboxylic acid, anthracenedicarboxylic acid, phenanthrenedicarboxylic acid, 9,9'-bis(4-carboxyphenyl)fluoren acid; ester derivatives thereof; which may be used alone or in combination of two or more. The polyester resin used for the P1 layer may be a homo-resin, a copolymer, or a blend of two or more mutually compatibilized polyester resins.

The dicarboxy compound may also be the one having an oxy acid such as 1-lactide, d-lactide, hydroxybenzoic acid, or a derivative thereof or two or more such oxy acids linked together condensed at the carboxy terminal of the dicarboxylic acid component as described above.

Typical diol components include aliphatic diols such as ethylene glycol, 1,2-propane diol, 1,3-propane diol, 1,4-butanediol, 1,2-butanediol, and 1,3-butanediol; alicyclic diols such as cyclohexane dimethanol, spiroglycol, and isosorbide; and aromatic diols such as bisphenol A, 1,3-benzene dimethanol, 1,4-benzene dimethanol, and 9,9'-bis(4-hydroxyphenyl)fluorene, which may be used alone or in combination of two or more. Other examples include dihydroxy compounds wherein a diol is condensed on the hydroxy terminal of the diol component as described above.

Typical compounds having carboxylic acid or carboxylic acid derivative skeleton and hydroxy group in one molecule of 2) include oxy acids such as 1-lactide, d-lactide, and hydroxybenzoic acid, and derivatives thereof; oligomer of the oxy acid; dicarboxylic acid having the oxy acid condensed on one carboxyl group of the dicarboxylic acid.

In the laminate sheet of the present invention, the polyester resin constituting the P1 layer may have a number average molecular weight of 18,500 to 40,000, and the number average molecular weight is more preferably 19,000 to 35,000, and even more preferably 20,000 to 33,000. When the polyester resin constituting the P1 layer has a number average molecular weight of less than 18,500, the product may suffer from insufficient long term durability. The number average molecular weight in excess of 40,000 may invite polymerization difficulty, and even if the polymerization cold be completed, film formation by the extrusion of the resin from an extruder may be difficult. Preferably, the P1 layer in the laminate sheet of the present invention is uniaxially or biaxially stretched since the long term durability can be improved by the crystal orientation in the stretching.

Small endothermic peak temperature of the P1 layer TmetaP1 obtained by the differential scanning calorimetry (DSC) is preferably in the range of TmP1 (the melting point of the P1 layer) - 90°C to TmP1 - 40°C, more preferably TmP1 - 80 to TmP1 - 50°C, and more preferably TmP1 - 75 to TmP1 - 55°C. When TmetaP1 is less than TmP1 - 90°C, residual stress in the stretching is not sufficiently relieved, and as a consequence, thermal contraction of the film increases to the extent that adhesion in the assembly of the solar cell becomes difficult, and even if the adhesion was possible, warping of the solar cell system will be greater when incorporated in the solar cell and used at high temperature. When the TmetaP1 is in excess of TmP1 - 40°C, crystalline orientation will be insufficient and wet heat resistance may become insufficient. In the laminate sheet of the present invention, the decrease in the contraction rate and the sufficient wet heat resistance can be simultaneously achieved when the TmetaP1 of the P1 layer is within the range as described above.

In the laminate sheet of the present invention, the melting point TmP1 of the P1 layer is preferably at least 220°C, more preferably at least 240°C, and still more preferably 250°C in view of the heat resistance. While the melting point TmP1 of the P1 layer is not limited for its upper limit, the melting point TmP1 is preferably up to 300°C in view of the productivity.

In the present invention, the P1 layer preferably contains at least 1% by weight and up to 30% by weight of titanium oxide particles in view of improving the light resistance and light reflectance. When the P1 layer has a laminate structure, the entire laminate structure of the P1 layer preferably contains at least 1% by weight and up to 30% by weight of titanium oxide particles. At such content, coloring of the sheet by the sheet deterioration in the long term use can be prevented by utilizing the UV resistance and light reflective properties of the titanium oxide particles. The UV resistance may become insufficient when the content is less than 1% by weight while content in excess of 30% by weight may result in the poor interlayer adhesion. The content is more preferably at least 2% by weight, and still more preferably at least 3% by weight, and the content is preferably up to 25% by weight, and still more preferably up to 20% by weight. In addition, the titanium oxide used is preferably rutile type titanium oxide considering the high reflection property and UV resistance. In the method used for the addition of the titanium oxide particles to the polyester resin constituting theP1 layer, the polyester resin and the titanium oxide particles are preferably melt kneaded in a vented biaxial kneader extruder or a tandem extruder. When the polyester resin experiences thermal hysteresis in this process of incorporating the titanium oxide particles, the polyester resin is considerably degraded. Accordingly, it is preferable to first prepare master pellets having a titanium oxide particle content higher than that of the P1 layer, and then mix and dilute these master pellets with the polyester resin to thereby realize the particular content of the titanium oxide particles of the P1 layer. This process is also preferable in view of the wet heat resistance.

In addition to the titanium oxide particles as described above, the P1 layer of the laminate sheet of the present invention may have various additives and bubbles incorporated to the extent not adversely affecting the merits of the present invention. Exemplary additives include thermal stabilizer, oxidation stabilizer, UV absorbent, UV stabilizer, organic and/or inorganic lubricant, organic and/or inorganic fine particles, filler, nucleating agent, dye, dispersant, and coupling agent. For example, when the additive selected is a UV absorbent, the laminate sheet of the present invention will have improved UV resistance. In addition, voltage resistance can be improved by adding an antistatic agent or the like, and reflectivity can be provided by incorporating an organic and/or inorganic fine particles or bubbles. Furthermore, design freedom can be improved by adding the material having the desired color. In the case of the application to be used in the exterior, long term prevention of the change in the color tone which is the merit of the present invention can be further improved by the addition of organic particles having UV absorbancy, for example, carbon materials such as carbon, fullerene, carbon fiber, or carbon nanotubes without sacrificing the design freedom.

The P1 layer of the present invention may have a laminate structure. An exemplary preferable embodiment is the laminate structure comprising the P11 layer having good wet heat resistance and a P12 layer containing a UV absorber or titanium oxide particles having a high UV absorbancy at a high concentration. When the P1 layer is such layer, the laminate sheet of the present invention is preferably prepared to have the constitution: P12 layer /P11 layer /P2 layer /P3 layer in view of the light resistance. In this case, the resin used for the P11 layer and the P12 layer may be adequately selected from the resins mentioned for the P1 layer as described above.

In the present invention, a layer having another function, for example, gas barrier property, UV resistance, or the like may be formed on one surface of the P1 layer (on the surface opposite to the surface in contact with the P2 layer). Such layer may be formed by separately forming the P1 layer and the material disposed on the P1 layer, and thermally pressing the films by heated rolls or the like (thermal lamination method); or adhesion by using an intervening adhesive (adhesion method), or alternatively, by dissolving the material to be laminated in a solvent and coating the solution on the preliminarily prepared P1 layer (coating method), by coating a curable material on the P1 layer and curing the coated material by electromagnetic irradiation, heating, or the like, by depositing the material to be laminated on the P1 layer by vapor deposition or sputtering, or combinations thereof.

The P1 layer of the present invention is a layer containing a polyethylene terephthalate (PET) resin as its main component, and the P1 layer may preferably have an intrinsic viscosity IV of at least 0.65 and up to 0.80, and a content of the terminal COOH of up to 25 eq./t. The lower limit of the content of the terminal COOH is 1 eq./t. The term "main component" used herein means that the PET resin constitutes more than 50% by weight of the P1 layer.

When the PET layer constituting the P1 layer has an intrinsic viscosity IV of less than 0.65, the sheet may have an insufficient wet heat resistance. On the other hand, an intrinsic viscosity IV in excess of 0.80 results in the poor extrudability of the resin in the formation of the P1 layer, and formation of the sheet may be difficult. Even if the intrinsic viscosity IV of the P1 layer within the range as described above, the content of the terminal COOH in excess of 25 eq./t is not preferable in view of the poor wet heat resistance of the sheet despite improvement of the adhesion with the P2 layer. Accordingly, the PET layer constituting the P1 layer can contribute for the production of a laminate sheet having excellent extrudability and long term durability when the intrinsic viscosity IV and the content of the terminal COOH are within the ranges as described above.

The P3 layer of the present invention contains a polyolefin resin as its main component. The term "main component" used herein means that the polyolefin resin constitutes more than 50% by weight of the P3 layer. Examples of the polyolefin resin used in the present invention include polyethylene, polypropylene, polybutene, polymethylpentene, polycycloolefin, polyhexene, polyoctene, polydecene, and polydodecene, and among these, the preferred are polyethylene (PE) and polypropylene (PP) in view of the relatively high processibility and low price. Of the polyethylene, use of low density polyethylene (LDPE) and linear low density polyethylene (LLDPE) having a relatively low density is preferable, and of the polypropylene, use of a homopolymer or a random copolymer is preferable. These polyolefm resins may be mixed or copolymerized with another olefin component, and use of a copolymer such as ethylene - propylene copolymer (EPC) or ethylene - propylene - butene copolymer (EPBC) contributes for the decrease of the resin crystallinity. A polyolefin elastomer may be mixed with the polyolefin resin, and exemplary polyolefin elastomers include those where ethylene - propylene rubber is micro-dispersed in the polypropylene and those comprising a polypropylene having another α-olefin copolymerization therewith. Exemplary α-olefins include 1-butene, 1-pentene, 1-hexene, 1-heptene, 1-octene, 1-nonene, 1-decene, 1-dodecene, and 4-methyl-1-pentene. The polyolefin elastomer preferably constitutes at least 5% by weight and up to 50% by weight of the P3 layer. Incorporation of the polyolefin elastomer contributes for the softness of the P3 layer, and curling of the laminate sheet is improved. Preferable content is at least 10% by weight and up to 30% by weight. Incorporation of the polyolefin elastomer in the P3 layer on the side to be adhered with the sealant is preferable in view of improving the wet heat resistance of the adhesion strength with the sealant.

The polyolefin resin and the polyolefin elastomer constituting the P3 layer of the present invention may be a commercially available product, and preferable examples include "THERMORUN" and "ZELAS" manufactured by Mitsubishi Chemical Corporation, "EXCELLEN", "TAFCELENE", "ESPRENE", "NOBLEN", and "Sumikasen L" manufactured by Sumitomo Chemical Co.,Ltd., "HYBRAR" and "SEPTON" manufactured by KURARAY Co.,Ltd., "Prime Polypro" manufactured by Prime Polymer Co., Ltd., "NOTIO" manufactured by Mitsui Chemicals, Incorporated, and "ENGAGE" manufactured by The Dow Chemical Company. In addition, the polyolefin resin constituting the P3 layer of the present invention preferably contains at least 70% by weight of propylene component in view of reducing the curl. In particular, in the case of incorporating a polyolefin elastomer, the propylene component is preferably used at an amount of at least 70% by weight, more preferably at least 80% by weight, and most preferably at least 90% by weight.

In the present invention, the P3 layer preferably contains at least 0.5% by weight and up to 20% by weight of titanium oxide particles in view of improving the light resistance and light reflectance. When the P3 layer has a laminate structure, the entire laminate structure of the P3 layer preferably contains at least 0.5% by weight and up to 20% by weight of titanium oxide particles. At such content, the transmitted light which was not converted by the solar cell is reflected due to the reflective properties of the titanium oxide particles, and this contributes for the improvement of the solar cell efficiency. The reflection property may become insufficient when the content is less than 0.5% by weight while content in excess of 20% by weight may result in the poor adhesion with the EVA layer. The content is more preferably at least 1% by weight, and still more preferably at least 2.5% by weight, and the content is preferably up to 15% by weight, and still more preferably up to 10% by weight. In addition, the titanium oxide used is preferably rutile type titanium oxide considering the high reflection property and UV resistance. In the method used for the addition of the titanium oxide particles to the polyolefin resin constituting the P3 layer, the polyolefin resin and the titanium oxide particles are preferably melt kneaded in a vented biaxial kneader extruder or a tandem extruder. When the polyolefin resin experiences thermal hysteresis in this process of incorporating the titanium oxide particles, the polyolefin resin is considerably degraded. Accordingly, master pellet having a content of the titanium oxide particles higher than that of the P3 layer is first prepared, and this master pellet is mixed and diluted with the polyolefin resin to thereby realize the particular content of the titanium oxide particles of the P3 layer. This process is preferable in view of the wet heat resistance.

The P3 layer of the present invention preferably contains a modified polyolefin resin for the purpose of improving the adhesion with the adhesive resin layer (P2 layer). The modified polyolefin resin is a resin containing an acid-modified polyolefin modified with an unsaturated carboxylic acid or its anhydride or a polyolefin modified with a silane coupling agent as its main component (the term "main component" used herein means that the content of the resin is at least 50% by weight in the entire resin).

Examples of the unsaturated carboxylic acid or its anhydride include acrylic acid, methacrylic acid, maleic acid, maleic anhydride, citraconic acid, citraconic anhydride, itaconic acid, itaconic anhydride, ester compound of monopoxy compound of the derivative thereof and the acid as mentioned above, reaction product of a polymer having a group capable of reacting with such acid and the acid, as well as their metal salts. Among these, the preferred is maleic anhydride. Examples of the silane coupling agent include vinyltriethoxysilane, methacryloyloxy trimethoxysilane, and γ-methacryloyloxypropyl triacetyl oxysilane, which may be used alone or in combination of two or more, and among these, the preferred are those graft-modified by such compounds.

Content of the modified polyolefin resin in the P3 layer of the present invention is preferably at least 1% by weight and up to 30% by weight in relation to the P3 layer. The content of less than 1% by weight is associated with the problem of the loss of the interlayer adhesion, while the content in excess of 30% by weight may result in the reduced long term durability. More preferably, the content is at least 5% by weight and up to 15% by weight.

Preferably, the P3 layer of the present invention has a laminate constitution, and more specifically, the P3 layer may preferably have a constitution of P31 layer, P32 layer, and P33 layer. In this case, the laminate sheet of the present invention may preferably have a constitution of P1 layer / P2 layer / P31 layer / P32 layer / P33 layer in this order while the laminate sheet may also have a constitution of P1 layer / P2 layer / P31 layer / P32 layer / P31 layer, or alternatively, P1 layer / P2 layer / P31 layer / P32 layer. When the P31 layer is a layer exhibiting a higher interlayer adhesion to the P2 layer and the P32 layer is a layer having an excellent wet heat resistance, the resulting solar cell backsheet will have excellent long term durability and wider application.

The method for selecting the polyolefin resins constituting the P31 layer, the P32 layer, and the P33 layer is not particularly limited. However, the polyolefin resin preferable for use as the P31 layer is the one exhibiting high compatibility with the modified polyolefin resin of the P2 layer and good adhesion with the P2 layer in view of the long term durability of the laminate sheet. When the laminate sheet of the present invention is used for the solar cell backsheet, the P32 layer and the P33 layer are preferably those exhibiting excellent gas barrier property as well as good adhesion with the sealant material in view of the long term durability of the solar cell. For example, when the modified polyolefin resin of the P2 layer is polypropylene resin, the resin constituting the P31 layer may be selected from those exhibiting good compatibility and good adhesion with the modified polypropyrene resin of the P2 layer. In this case, the resins used for the P31 layer, the P32 layer, and the P33 layer may be adequately selected from those as mentioned above for the P3 layer.

The thickness ratio of the P31 layer, the P32 layer, and the P33 layer is not particularly limited, and the constitution of the thickness of the layers may be adequately determined so that each layer can fulfill the functions inherent to each layer.

The laminate sheet of the present invention needs the P2 layer which is an adhesive resin layer that bonds the P1 layer with the P3 layer. The method used for the sheet lamination is not particularly limited, and any method known in the art may be used for the lamination. The methods particularly suitable for the present invention are dry lamination and melt extrusion lamination. When the P1 layer and the P3 layer are to be adhered with each other, the P2 layer may contain polyether polyurethane resin, polyester polyurethane resin, polyester resin, polyepoxy resin, acryl resin, or the like as its main component, and polyisocyanate resin, epoxy resin, melamine resin, oxazoline resin, or the like as its crosslinking agent. When the P2 layer are formed by using such adhesive resin, the resin may be used either alone or in combination of two or more, and delamination caused by the loss of adhesion strength due to the long term use in the exterior and yellowing which results in the loss of light reflectance should be avoided. Preferably, a polyurethane resin such as a polyether urethane resin or a polyester urethane resin is incorporated as the main ingredient and an epoxy resin is incorporated as the crosslinking agent in the present invention in order to improve the interlayer adhesion and the interlayer adhesion after the wet heat resistance test. A polyurethane resin is a resin containing urethane bond in its backbone which can be obtained, for example, by the reaction between a polyol compound and a polyisocyanate compound, and the one containing an anionic group is preferable in view of higher dispersion in an aqueous medium. The term "anionic group" as used herein means a functional group which becomes an anion in an aqueous medium and examples include carboxyl group, sulfonic acid group, sulfuric acid group, and phosphoric acid group. The polyol component constituting the polyurethane resin is not particularly limited, and examples include water; low molecular weight glycols such as ethyleneglycol, diethylene glycol, triethylene glycol, 1,3-butanediol, 1,4-butanediol, 1,2-propane dio1,1,3-propane diol,1,6-hexanediol, neopentyl glycol, 1,4-cyclohexane dimethanol, methyl-1,5-pentanediol, 1,8-octane diol, 2-ethyl-1,3-hexanediol, diethylene glycol, triethylene glycol, and dipropylene glycol; low molecular weight polyols such as trimethylolpropane, glycerin, and pentaerythritol; polyol compounds containing ethylene oxide or propylene oxide units; high molecular weight diols such as polyether diols and polyester diols; bisphenols such as bisphenol A and bisphenol F; and dimer diols prepared by converting the carboxyl group of the dimer acid to hydroxy group.

In the meanwhile, the polyisocyanate component may be one of the known aromatic, aliphatic, and alicyclic diisocyanates or a mixture thereof. Exemplary such diisocyanates include tolylenediisocyanate, 4,4' -diphenylmethanediisocyanate, 1,3-phenylene diisocyanate, hexamethylenediisocyanate, xylylenediisocyanate, 1,5-naphtylene diisocyanate, isophoronediisocyanate, dimeryldiisocyanate, lysine diisocyanate, hydrogenated 4,4' -diphenylmethanediisocyanate, hydrogenated tolylenediisocyanate, dimer diisocyanate prepared by converting the carboxyl group of the dimmer acid to isocyanate group, and adducts, biuret compound, and isocyanurate compounds thereof. The diisocyanate used may be a polyisocyanate having three or more functionality such as triphenylmethanetriisocyanate and polymethylenepolyphenylisocyanate.

The introduction of the anionic group in the polyurethane resin may be conducted by using a polyol component having carboxyl group, sulfonic acid group, sulfuric acid group, phosphoric acid group, or the like. Examples of the polyol compounds containing the carboxyl group include 3,5-dihydroxybenzoic acid, 2,2-bis(hydroxymethyl)propionic acid, 2,2-bis(hydroxyethyl)propionic acid, 2,2-bis(hydroxypropyl) propionic acid, bis(hydroxymethyl)acetic acid, bis(4-hydroxyphenyl)acetic acid, 2,2-bis(4-hydroxyphenyl)pentanoic acid, tartaric acid, N,N-dihydroxyethyl glycine, and N,N-bis(2-hydroxyethyl)-3-carboxyl-propionamide.

The molecular weight of the polyurethane resin may also be adjusted by using a chain extender. The chain extender may be a compound having at least two active hydrogen atoms such as amino group or hydroxy group capable of reacting with the isocyanate group, and examples include diamine compounds, dihydrazide compounds, and glycol.

The P2 layer preferably contains a modified polyolefin resin in order to improve adhesion between the P1 layer and the P3 layer. The modified polyolefin resin is a resin containing an acid-modified polyolefin modified with an unsaturated carboxylic acid or its anhydride or a polyolefin modified with a silane coupling agent as its main component (the term "main component" used herein means that the content of the resin is at least 50% by weight in the entire resin).

Examples of the modified polyolefin resin of the P2 layer include those prepared by modifying polyolefin resins such as alkenes such as propylene, 1-butene, isobutene, 1-pentene, 4-methyl-1-pentene, 3-methyl-1-pentene, and 1-hexene, and dienes such as butadiene and isoprene. Among these, the polyolefin resin component of the P2 layer is propylene component or butene component (1-butene, isobutene, etc.) or both in view of the ease of the resin production, ease of producing an aqueous resin, adhesion to various materials, and blocking property. Furthermore, the polyolefin resin component may also contain ethylene component, and inclusion of such ethylene component facilitates production of an aqueous resin and improvement of the coated film properties.

With regard to the polyolefin resin component as described above, the form of the copolymerization of the component is not particularly limited, and exemplary copolymers include random copolymer and block copolymer. For the ease of polymerization, the preferred is the random copolymer. A mixture of two or more polyolefin resins mixed to realize the component ratio of the present invention may also be used.

The modified polyolefin resin of the P2 layer of the present invention is a polyolefin modified with an unsaturated carboxylic acid or its anhydride or a silane coupling agent. Examples of the unsaturated carboxylic acid or its anhydride include acrylic acid, methacrylic acid, maleic acid, maleic anhydride, citraconic acid, citraconic anhydride, itaconic acid, itaconic anhydride, ester compound of monoepoxy compound of the derivative thereof and the acid as mentioned above, reaction product of a polymer having a group capable of reacting with such acid and the acid, as well as their metal salts. Examples of the silane coupling agent include vinyl triethoxysilane, methacryloyloxy trimethoxysilane, and $\gamma$-methacryloyloxypropyl triacetyl oxysilane. Among these, the preferred are maleic anhydride, acrylic acid, and methacrylic acid, and in particular, maleic anhydride, in view of the ease of introduction in the polyolefin resin. These unsaturated carboxylic acids or anhydride thereof may be copolymerized in the polyolefin resin, and the form is not particularly limited. Exemplary forms include random copolymer, block copolymer, and graft copolymer.

The method used for introducing the unsaturated carboxylic acid in the polyolefin resin is not particularly limited. Exemplary methods include a method wherein the polyolefin resin and the unsaturated carboxylic acid are melted by heating to a temperature not less than the melting point of the polyolefin resin to promote the reaction in the presence of a radical initiator, and a method wherein the polyolefin resin is first dissolved in an organic solvent, and the solution is heated and agitated to promote the reaction in the presence of a radical initiator. Graft copolymerization of the unsaturated carboxylic acid unit with the polyolefin resin is thereby promoted. The preferred is the former method in view of the ease of the process.

Examples of the radical initiator used in the graft copolymerization include organic peroxides such as di-tert-butyl peroxide, dicumyl peroxide, tert-butyl hydroperoxide, tert-butylcumyl peroxide, benzoyl peroxide, dilauryl peroxide, cumenehydroperoxide, tert-butylperoxy benzoate, ethylethyl ketone peroxide, and di-tert-butyl diperphthalate and azonitriles such as azobisisobutyronitrile, which may be adequately selected according to the reaction temperature.

The polyurethane resin used is preferably the one having the urethane bond in the backbone, for example, the one obtained by the reaction between a polyol compound and a polyisocyanate compound, and in view of the higher dispersion in the aqueous medium, the preferred is the one containing an anionic group. The term "anionic group" as used herein means a functional group which becomes an anion in an aqueous medium and examples include carboxyl group, sulfonate group, sulfate group, and phosphate group.

The ratio W2a/W2b of the content W2a of the modified polyolefin resin to the content W2b of the polyurethane resin in the P2 layer is preferably at least 0.1 and up to 9. The modified polyolefin resin contributes to the adhesion with the P3 layer while the polyurethane resin contributes to the adhesion with the P1 layer, and therefore, the W2a/W2b of less than 0.1 or greater than 9 may result in the weak interlayer adhesion between the polyester P1 layer and the olefin P3 layer. For this layer, particles of the modified polyolefin resin may be adequately mixed, or a commercially available composition which has the modified polyolefin resin preliminarily mixed therewith may be used.

Exemplary solvents used for the formation of the coating composition for the P2 layer of the present invention include toluene, xylene, ethyl acetate, butyl acetate, acetone, methyl ethyl ketone, methyl isobutyl ketone, tetrahydrofuran, dimethylformamide, dimethyl acetamide, methanol, ethanol, and water, and the coating composition may be either an emulsion or a solution. Among these, the preferred is the emulsion-type coating composition prepared by using water for the main solvent in view of recent attention to environmental saving of natural resources, and discharge of organic solvent in the production. In the case of the coating composition prepared by using water for the solvent, the solvent may also contain a solvent which is used for emulsification of the resin component or an organic solvent which is used as a dispersion aid.

The method used for preparing an aqueous emulsion from the modified polyolefin resin or the polyurethane resin is not particularly limited, and the production may be accomplished by using a solid/liquid agitator or emulsifier device widely known to those skilled in the art.

The method used for the formation of the P2 layer on the P layer is not particularly limited, and the formation of the P2 layer may be accomplished by any known coating method. The coating may be conducted by various methods such as roll coating method, dip coating method, bar coating method, die coating method, coating method, or a combination of such methods. In-line formation of the adhesive layer by using a known coating method during the formation of the substrate polyester film is also preferable in view of the simple production process.

When the P2 layer is cured after the coating, the curing may be accomplished by any known means such as thermal curing, curing by the use of an active beam such as UV beam, electron beam, or radiation, or a combination of these methods. In the present invention, the preferred is the thermal curing in a hot air oven. In the curing by using a hot air oven, the process of stepwise temperature elevation wherein the drying temperature is raised in the steps of preliminary heating, constant rate of drying, and decreasing rate of drying is preferable in view of the reducing the solvent left in the P2 layer. Additional aging after the drying step at an adequate temperature is also preferable in view of promoting crosslinking between the main ingredients and the curing agent.

The P2 layer of the present invention may have a laminate structure for the purpose of improving the adhesion between the P1 layer and the P3 layer. In a preferable embodiment, an anchor coating layer (P21 layer) may be preliminarily formed on one surface of the P1 layer, and a layer compatible with the P3 layer (P22 layer) may be formed on the anchor coating layer (P21 layer). In this case, the sheet is constituted in the order of P1 layer / P21 layer / P22 layer / P3 layer, and the thickness of the P2 layer will be P21 layer + P22 layer. The P21 layer and the P22 layer are not particularly limited as long as the P21 layer exhibits good adhesion with the resins constituting the P1 layer and the P22 layer , and the P22 layer exhibits good adhesion with the resin constituting the P21 layer and the P3 layer, and the compatibility is exhibited at a temperature not lower than the softening point constituting the P3 layer. The resin used for the P21 layer and the P22 layer may be adequately selected from the resins mentioned for the P2 layer as described above.

The method used for the formation of the P22 layer on the P21 layer is not particularly limited, and the formation of the P22 layer may be accomplished by any known coating method. The coating may be conducted by various methods such as roll coating method, dip coating method, bar coating method, die coating method, gravure coating method, or a combination of such methods.

The P2 layer in the present invention may optionally contain additives such as thermal stabilizer, lubricating agent, antistatic agent, antiblocking agent, dye, pigment, photosensitizer, surfactant, UV absorbent which are known in the art , if necessary.

In view of the UV resistance of the laminate sheet, change in the color tone Δb when the incident surface is P1 layer is preferably up to 10. The change in the color tone Δb is the value calculated from the value K0 measured by irradiating the laminate sheet before the UV treatment from the side of the P1 layer and the value K measured by irradiating the laminate sheet after the UV treatment from the side of the P1 layer. The Δb is preferably up to 6, and more preferably up to 3. A preferable method for realizing the change in the color tone Δb of up to 10 is addition of at least 3% by weight of titanium oxide particles to the P1 layer, and change in the color tone Δb can be reduced by changing amount of the titanium oxide particles added.

In view of the gas barrier properties, the laminate sheet of the present invention preferably has a water vapor permeability of at least 0.0001 $g/m^2$.day and up to 10 $g/m^2$.day, more preferably at least 0.0001 $g/m^2$.day and up to 5 $g/m^2$.day, and most preferably at least 0.0001 $g/m^2$.day and up to 3 $g/m^2$.day. When the water vapor permeability is within such range, deterioration of the interior of the solar cell by the gas permeation from the backsheet to the sealant can be prevented. The water vapor permeability used herein is the value measured according to JIS-K7129 B (1992). In the present invention, the water vapor permeability can be adjusted by the thickness of the P3 layer, and the water vapor permeability decreases with the increase in the thickness.

Next, the production method of the laminate sheet of the present invention is described by referring to embodiments which by no means limit the scope of the present invention.

First, the production method of the resin composition constituting the P1 layer is as described below.

The resin of the P1 layer of the present invention may be produced by interesterification of a dicarboxylic acid or its ester derivative with a diol by a method known in the art. Exemplary conventional known reaction catalysts include alkaline metal compound, alkaline earth metal compound, zinc compound, lead compound, manganese compound, cobalt compound, aluminum compound, antimony compound, titanium compound, and phosphorus compound. Preferably, an antimony compound, a germanium compound, or a titanium compound is added as a polymerization catalyst at any stage before the completion of the PET production process. In the case of germanium compound, such addition is preferably accomplished, for example, by adding a powder of the germanium compound without further processing. In order to control the number average molecular weight of the polyester resin to the range of 18,500 to 40,000, the resin is preferably prepared by the so called "solid phase polymerization" wherein the a polyester resin of normal molecular weight having a number average molecular weight of about 18,000 is first prepared by the method as described above, and then heating to a temperature of from 190°C to the melting point of the thermoplastic resin under reduced pressure or in the stream of inert gas such as nitrogen gas. This method is preferable since the number average molecular weight can be increased without increasing content of the terminal carboxyl group of the thermoplastic resin.

Next, the method for the formation of the P1 layer is described. When the P1 layer has monolayer constitution, the resin composition for the P1 layer is heated in the extruder, and the molten resin composition is extruded from the nozzle onto a cooled casting drum to form a sheet (melt casting). In another method, the resin composition for the P1 layer is dissolved in a solvent, and the solution is extruded from the nozzle onto a support such as cast drum or endless belt to form a film, and subsequently, the solvent is removed from the film layer by drying to thereby obtain the sheet (solution casting).

When the P1 layer has a laminate structure and a thermoplastic resin is the main component of each layer, the P1 layer may be formed by respectively introducing two different thermoplastic resins in two extruders, and extruding the molten resin from the nozzle onto a cooled casting drum to form a sheet (co-extrusion), or by introducing the resin composition for the covering layer in an extruder and extruding the molten resin from the nozzle onto the sheet which has been formed as a single film for lamination (melt lamination).

When the laminate including the P1 layer and/or the P1 layer is a uniaxially or biaxially stretched film substrate, the production may be conducted as described below. The resin composition is first introduced in the extruder (two or more extruders in the case of a laminate structure), and then, the molten resin is extruded from the nozzle (co-extrusion in the case of the laminate structure) onto a cooled drum having a surface temperature of 10 to 60°C where the sheet is electrostatically adhered to the drum. The unstretched film is thereby prepared.

The unstretched film is then guided to rolls heated to a temperature of 70 to 140°C, and stretched 3 to 4 times in axial direction (machine direction, namely, in the direction of film movement) and cooled by rolls at a temperature of 20 to 50°C.

Next, the film is guided to a tenter with its opposite edges held by clips, and the film is stretched 3 to 4 times in a direction perpendicular to the axial direction (transverse direction) in an atmosphere heated to a temperature of 80 to 150°C.

The film is stretched 3 to 5 times in both the axial direction and in the width (transverse) direction, and preferably, 9 to 15 times in area (axial stretching x transverse stretching). When the stretching in area is less than 9 times, the resulting biaxially stretched laminate film will suffer from insufficient long term durability while the stretching in area in excess of 15 times is likely to result in the film breakage during the stretching.

The biaxial stretching may be accomplished either by sequential biaxial stretching wherein the stretching in the axial direction and the stretching in the transverse direction are separately conducted, or by simultaneous biaxial stretching wherein the stretching in the axial direction and the transverse direction are simultaneously conducted.

When the formation of the P2 layer is conducted by in-line coating provided in the step of forming the P1 layer, the coating step may be provided after the uniaxial film stretching in the case of the sequential biaxial stretching, and after the formation of the un-stretched film in the case of the simultaneous biaxial stretching to thereby coat the coating composition for the P2 layer. If desired, the surface of the substrate layer (P1 layer) may be preliminarily treated immediately before the coating step, for example, by corona treatment in view of improving the wettability and adhesion property of the substrate to the coating composition.

In order to complete the crystal orientation the resulting biaxially stretched film to provide the surface flatness and the size stability with the film, heat treatment of the film is conducted also in the tenter preferably at a temperature of at least the Tg and less than the melting point of the resin for 1 to 30 seconds, and then, the film is cooled to room temperature after homogeneous gradual cooling. A heat treatment conducted at a low temperature typically results in an increased film thermal contraction, and therefore, the heat treatment is preferably conducted at a higher temperature for realizing a high thermal size stability. On the other hand, an excessively high heat treatment temperature results in the poor crystal orientation, and the resulting film may suffer from an insufficient wet heat resistance. Accordingly, the temperature used in the present invention for the heat treatment of the P layer is preferably in the range of TmP1-90 to TmP1-40°C, more preferably TmP1-80 to TmP1-50°C, and still more preferably TmP1-75 to TmP1-55°C. Furthermore, when the P1 layer of the present invention is used for the backsheet of a solar cell, the sheet may be exposed to the atmospheric temperature as high as approximately 100°C, and accordingly, the heat treatment temperature is in the range of 160°C to TmP1-40°C (with the provision that TmP1-40°C > 160°C), more preferably 170 to TmP1-50°C (with the provision that TmP1-50°C > 170°C), still more preferably 180 to TmP1-55°C (with the provision that TmP1-55°C > 180°C). In the heat treatment, a film relaxation of 3 to 12% may be optionally conducted in either the transverse direction or axial direction.

If desired, the film may be subjected to a corona discharge treatment and then wound to form the substrate layer of a film to be used for a solar cell backsheet.

The method used for the formation of the P2 layer on the P1 layer is not limited to the in-line coating as described above. Exemplary methods include the method wherein the resin composition for the P1 layer and the resin composition for the P2 layer are respectively melted in the respective extruders by using a plurality of extruders and the resins are co-extruded from the nozzle onto the cooled casting drum to form a sheet (co-extrusion method), the method wherein the resin composition for the P2 layer is introduced and melted in an extruder and the molten resin is extruded from the nozzle onto the substrate P1 layer which has been formed as a single film for lamination (melt lamination method), separate preparation of the P1 layer and the P2 layer and thermally pressing these layers by using heated rolls or the like (thermal adhesion method), and adhesion by using an adhesive (adhesion method), and also, the method wherein the resin composition for the P2 layer is dissolved or dispersed in a solvent and the resulting solution or the dispersion is coated on the preliminarily prepared substrate P1 layer (coating method) and combination of these methods.

In the present invention, co-extrusion and coating methods are preferable due to the ease of forming the P2 layer. When the P2 layer is formed on the substrate P1 layer by co-extrusion, the resin composition for the P layer and the resin composition for the P2 layer may be respectively melted in a plurality of extruders and co-extruded from the nozzle, and the extruded sheet may be electrostatically adhered onto a drum having the surface cooled to a temperature of 10 to 60°C to thereby obtain a sheet having the P2 layer on the P1 layer.

In forming the P2 layer on the substrate P1 layer by the coating method, the coating may be accomplished by an in-line coating method wherein the P2 layer is coated during the formation of the substrate P1 layer as described above, or by an off-line coating method wherein the P2 layer is coated the preliminarily formed substrate P1 layer. The preferred is, however, the in-line coating method since the P2 layer can be efficiently formed simultaneously with the formation of the substrate P1 layer and also in view of the strong adhesion between the P2 layer and the P1 layer. In view of improving the adhesion of the P1 layer and the P3 layer, a P22 layer may be formed by the off-line coating on the P21 layer which had been formed on the P1 layer by the in-line coating.

In forming the P2 layer on the substrate P1 layer by the coating method as described above, the coating composition prepared by dissolving or dispersing material for the P2 layer in the solvent is coated and dried on the substrate P1 layer. While the solvent used in this procedure is not particularly limited, the preferable solvent used in the inline coating method is water in view of safety. In this case, a small amount of organic solvent soluble in water can be added for improving coating property or solubility. Non-limiting examples of such organic solvents include aliphatic or alicyclic alcohols such as methyl alcohol, ethyl alcohol, isopropyl alcohol, n-propyl alcohol, and n-butyl alcohol; diols such as ethylene glycol, propylene glycol, and diethylene glycol; diol derivatives such as methyl cellosolve, ethyl cellosolve, and propylene glycol monomethyl ether; ethers such as dioxane and tetrahydrofuran; esters such as methyl acetate, ethyl acetate, and amyl acetate; ketones such as acetone, and methyl ethyl ketone; amides such as N-methylpyrrolidone; and mixtures thereof.

Particularly preferred is the production of the laminate sheet of the present invention by forming a sheet of the resin composition for the P1 layer, and coating the coating composition containing the resin composition for the P2 layer on at least one surface of the P1 layer after optional uniaxial stretching of the P1 layer, and then uniaxially or biaxially stretching the laminate.

With regard to the laminate sheet of the present invention, the formation of the P1 layer, the P2 layer, and the P3 layer in this order may be conducted, for example, by forming the P2 layer on the preliminarily formed P1 layer, introducing and melting the resin composition for the P3 layer in the extruder and extruding the composition for adhesion with the P2 layer to thereby form a sheet (melt extrusion lamination method); separately preparing the films and thermally pressing the films by heated rolls and the like (thermal lamination method); or adhesion by using an intervening adhesive (adhesion method), and also, by dissolving in a solvent and coating and drying the solution (coating method), or combinations thereof. Of these, the preferred is the melt extrusion lamination method considering the short production step and good interlayer adhesion. More specifically, the production method of the laminate sheet of the present invention preferably comprises a step of forming the P3 layer on a sheet having the P2 layer having a thickness of up to 3 μm on at least one side of the P1 layer by melt extrusion lamination. The production method is described in detail for the case of the melt extrusion lamination method.

When the laminate sheet of the present invention is prepared by melt extrusion lamination, the resin composition for the P3 layer is supplied to the extruder under the nitrogen stream, and the molten resin composition is extruded from the die to form the P3 layer. When the P3 layer is a laminate of the P31 layer, the P32 layer, and the P33 layer each having different composition, the laminate may be co-extruded by using a multi-manifold die, feed block, static mixer, pinole, or the like so that the resin compositions for the P31 layer, the P32 layer, and the P33 layer are laminated one on another. When the P31 layer, the P32 layer, and the P33 layer have greatly different melt viscosity, use of a multi-manifold is preferable in view of suppressing uneven lamination.

The P3 layer is extruded from the die by the method as described above onto the cooled member such as casting drum, and the preliminarily set substrate P1 layer is supplied so that the side of the P layer provided with the P2 layer will be in contact with the P3 layer. The layers are pressed with rolls, and the laminate sheet of the present invention is thereby obtained. At this stage, the cooled member such as casting drum is preferably kept at a temperature of at least 10°C and up to 40°C in view of the anti-curling property of the resulting sheet.

If desired, the laminate sheet of the present invention prepared by the method as described above may be further processed by a heat treatment or aging to the extent not adversely affecting the merits of the present invention. The upper limit of the heat treatment temperature is a temperature 10°C lower than the glass transition temperature, more preferably, a temperature 20°C lower than the glass transition temperature, and still more preferably, a temperature 30°C lower than the glass transition temperature of the resin constituting the P1 layer considering the surface flatness of the sheet and the like. The heat treatment time is at least 5 seconds and up to 48 hours. The heat treatment contributes to the improvement of the adhesion of the laminate sheet of the present invention. If desired, a corona treatment or a plasma treatment may be carried out to further improve the adhesion of the laminate sheet of the present invention prepared by the method as described above.

The solar cell is characterized by the use of the laminate sheet of the present invention for the backsheet. The use of the laminate sheet of the present invention results in the improved durability and reduced thickness compared to conventional solar cells. The constitution example is shown in FIG. 1. The photovoltaic element connected to the lead for taking electricity out of the cell (not shown in FIG. 1) is sealed with a transparent sealant layer 2 of the EVA resin or the like, and a transparent substrate 4 of glass and the laminate sheet of the present invention as the backsheet 1 for the solar cell are adhered. The constitution is not limited to the one shown in FIG. 1, and the laminate sheet may be used for the solar cell of any constitution. While FIG. 1 shows the constitution wherein the laminate sheet of the present invention is used alone, the laminate sheet of the present invention may be used as a complex sheet with other films to meet the specific properties which are required to be necessary.

In the laminate sheet of the present invention, the backsheet 1 for the solar cell is disposed on the rear side of the sealant layer 2 sealing the photovoltaic element. The backsheet 1 is preferably arranged so that the P1 layer of the laminate sheet of the present invention is on the side opposite to the sealant layer 2 (6 in FIG. 1). This constitution enables improvement of the resistance to UV ray reflected by the ground, and a highly durable solar cell and thin solar cell can be produced. When the laminate sheet of the present invention has asymmetric constitution and the other side is constituted by the P1 layer, the P3 layer is preferably arranged on the side of the sealant layer 2 in view of improving the adhesion with the sealant.

Photovoltaic element 3 converts optical energy of the sunlight to electric energy, and any element selected from crystalline silicon elements, polycrystalline silicon elements, microcrystalline silicon elements, amorphous silicon elements, copper indium selenide elements, compound semiconductor elements, dye sensitized elements, and the like may be used depending on the intended use, and two or more elements may be serially or parallelly connected depending on the desired voltage or current. Since the transparent substrate 4 is located at the outermost layer of the solar cell, a transparent material having not only the high transparency but also high weatherability, high anti-fouling property, and high mechanical strength is used. In the solar cell prepared by using the laminate sheet of the present invention, the transparent substrate 4 may be any material as long as the properties as described above are satisfied. Examples include glass, fluororesins such as tetrafluoroethylene - ethylene copolymer (ETFE), polyfluorovinyl resin (PVF), polyfluorovinylidene resin (PVDF), polytetrafluoroethylene resin (TFE), tetrafluoroethylene - hexafluoro propylene copolymer (FEP), polytrifluoroethylene chloride resin (CTFE), and polyfluorovinylidene resin, olefin resins, acryl resins, and mixtures thereof. In the case of glass, use of a tempered glass is preferable. When a resin transparent substrate is used, the resin can be used preferably after the uniaxially or biaxially stretching in view of the mechanical strength. The surface of the substrate may be subjected to corona treatment, plasma treatment, ozone treatment, adhesion promoting treatment, and the like in order to enable adhesion with the EVA resin which is the sealant material of the photovoltaic element.

A material having high transparency, high weatherability, high adhesion, and high heat resistance is used for the sealant material 2 for sealing the photovoltaic element since the sealant material is used for resin coverage of the surface irregularities on the surface of the photovoltaic element to thereby protect and electrically insulate the photovoltaic element from the exterior environment, and for the adhesion of the photovoltaic element to the substrate or backsheet having the transparency. Preferable examples include ethylene - vinyl acetate copolymer (EVA), ethylene - methyl acrylate copolymer (EMA), ethylene - ethyl acrylate copolymer (EEA) resins, ethylene - methacrylic acid copolymer (EMAA), ionomer resin, polyvinyl butyral resin, and mixtures thereof.

As described above, incorporation of the solar cell backsheet using the laminate sheet of the present invention in the solar cell system realizes a solar cell system having higher durability and/or reduced thickness compared to the conventional solar cell systems. The solar cell prepared by using the laminate sheet of the present invention can be used preferably in a wide variety of applications, for example, for the photovoltaric power generation cell, the power source of small size electronic parts, and so on for both exterior and interior applications.

[Measurement and evaluation of the properties]

(1) Total thickness of the laminate sheet and thickness of P1 layer, P2 layer, and P3 layer

A slice in the direction perpendicular to the surface of the laminate sheet was prepared by using a microtome, and the cross section was observed with a field emission scanning electron microscope "JSM-6700 F" (manufactured by JEOL Ltd.) at a magnification of 3000. The total thickness of the laminate sheet and the thickness of each of the P1 layer, the P2 layer, and the P3 layer were measured from the cross section, and more specifically, the thickness was determined by reverse calculation from the magnification. 5 randomly selected pictures of different measurement fields were used to measure the thickness, and the average was used.

(2) Surface flatness (anti-curling property)

Test pieces of 100 mm x 100 mm (width) were prepared from the laminate sheet having a thickness of at least 30 $\mu$m, and the test pieces were placed on a flat surface with the recessed side facing upward and with no load placed thereon. Heights of four corners of the test piece from the flat surface were measured, and the total value of the heights of the four corners was used as the curling height, and evaluation was conducted by the following criteria.

    total height of 4 corners is less than 20 mm: S
    total height of 4 corners is at least 20 mm and less than 50 mm: A
    total height of 4 corners is at least 50 mm and less than 100 mm: B
    total height of 4 corners at least 100 mm: C
    "S" to "B" are acceptable, and "S" is excellent.

(3) Content of titanium oxide particles (Wt1, Wt2)

The P1 layer and the P3 layer were respectively shaved or peeled off the laminate sheet to separate each of the P1 layer and the P3 layer from the laminate sheet, and content Wt1 and content Wt2 of the inorganic particles in the P1 layer and the P3 layer were respectively determined by the procedure as described below.

For the P1 layer, weight wt1 (g) of the shaved P1 layer was measured. Next, the shaved layer was dissolved in o-chlorophenol, and the inorganic particles were separately collected from the insoluble content by centrifugation. The resulting inorganic particles were washed with o-chlorophenol and separated by centrifugation. The washing was repeated until turbidity was no longer observed when acetone was added to the solution used for the washing after the centrifugation. The weight wt1' (g) of the resulting inorganic particles was then determined, and the content of the inorganic particles Wt1 was calculated by the following equation (3):

$$\text{Inorganic particle content (Wt1, \% by weight)}$$
$$\text{of the P1 layer} = (\text{wt1'}/\text{wt1}) \times 100 \quad \ldots (3)$$

The procedure as described above for the P1 layer was repeated except that the solvent used for the dissolution of the P3 layer was changed to o-dichlorobenzene (100°C) to thereby determine the inorganic particle content Wt2 of the P3 layer.

(4) Interlayer adhesion

The interlayer adhesion strength of the laminate sheet was measured according to JIS K 6854-3 (the edition of 1994). The term "interlayer" means the interface where the interfacial peeling takes place, for example, the interface between the P1 layer and the P2 layer, or the interface between the P2 layer and the P3 layer. The interlayer adhesion strength between the polyester layer and the olefin layer was measured by preparing a 15 mm x 150 mm test piece of the laminate sheet. When the polyester layer and the olefin layer were unpeelable, the measurement was conducted after immersing the edge of the test piece in ethyl acetate and leaving in the atmosphere at a temperature of 25°C and a relative humidity of 60% for 24 hours. The peeling was conducted at 90° for 3 times for both the axial and the transverse directions of the sheet, and the average was calculated. The interlayer adhesion strength E0 was determined by the following criteria:

    peel strength is at least 15 N/15 mm: S
    peel strength is at least 10 N/15 mm and less than 15 N/15 mm: A
    peel strength is at least 5 N/15 mm and less than 10 N/15 mm: B
    peel strength is less than 5 N/15 mm: C
    "S" to "B" are acceptable, and "S" is excellent.

(5) Interlayer adhesion after the wet heat resistance test

15 mm x 150 mm test pieces of the laminate sheet were prepared from the laminate sheet, and the test pieces were treated by a pressure cooker manufactured by Tabai Espec Corporation at a temperature of 120°C and a relative humidity of 100% for 48 hours. Subsequently, interlayer adhesion strength E1 after the wet heat resistance test was measured according to the (4) as described above. By using the interlayer adhesion strength E0 measured in the (4) as described above and the interlayer adhesion strength E1 after the wet heat resistance test, retention of the strength was then calculated by the following equation (4).

$$\text{Strength retention (\%)} = E1/E0 \times 100 \quad ... (4)$$

The resulting strength retention was evaluated by the following criteria:

strength retention is at least 50%: S
strength retention is at least 40% and less than 50%: A
strength retention is at least 30% and less than 40%: B
strength retention is less than 30%: C
interlayer adhesion strength E1 is not measurable due to the sheet breakage: D
"S" to "B" are acceptable, and "S" is excellent.

(6) Water vapor permeability

The water vapor permeability was measured under the conditions including the temperature of 40°C and the relative humidity 90% according to JIS K 7129, B (1992) by using a water vapor permeability tester PERMATRAN W-TWIN manufactured by MOCON. One test was conducted for each of the two test pieces, and average of the two measurements was calculated to determine the value of the water vapor permeability.

water vapor permeability is less than 3 $g/m^2$.day: S
water vapor permeability is at least 3 $g/m^2$.day and less than 5 $g/m^2$.day: A
water vapor permeability is at least 5 $g/m^2$.day and up to 10 $g/m^2$.day: B
water vapor permeability is in excess of 10 $g/m^2$.day: C
"S" to "B" are acceptable, and "S" is excellent.

(7) Adhesion strength with the sealant (EVA)

Adhesion strength with the EVA sheet was measured according to JIS K 6854-2 (1994). An EVA sheet was disposed on the olefin layer surface of the laminate sheet, and a semi-tempered glass having a thickness of 3 mm was disposed on the EVA sheet, and a pseudo solar cell module sample was prepared by reducing the pressure using a commercially available glass laminator and pressing the laminate with the load of 29.4 $N/cm^2$ by heating to 135°C for 15 minutes. The EVA sheet used was a sheet having a thickness of 500 $\mu$m manufactured by SANVIC Inc. The test piece used for the adhesion strength test had a width of 10 mm, and the peeling was conducted at an angle of 180°. The measurement was conducted for 3 test pieces, and average of the 3 test pieces was used for the value of the adhesion strength. The evaluation was conducted by the following criteria.

adhesion strength is at least 60 N/10 mm: SS
adhesion strength is at least 40 N/10 mm and less than 60 N/10 mm: S
adhesion strength is at least 30 N/10 mm and less than 40 N/10 mm: A
adhesion strength is at least 20 N/10 mm and less than 30 N/10 mm: B
adhesion strength is less than 20 N/10 mm: C
"SS" to "B" are acceptable, and "SS" is excellent.

(8) Adhesion strength with the sealant (EVA) after the wet heat resistance test

An EVA sheet was disposed on the olefin layer surface of the laminate sheet, and a semi-tempered glass having a thickness of 3 mm was disposed on the EVA sheet, and a pseudo solar cell module sample was prepared by reducing the pressure using a commercially available glass laminator and pressing the laminate with the load of 29.4 $N/cm^2$ by heating to 135°C for 15 minutes. The sample was treated by a pressure cooker manufactured by Tabai Espec Corporation at a temperature of 120°C and a relative humidity of 100% for 48 hours. Subsequently, adhesion strength with the sealant (EVA) after the wet heat resistance test was measured according to (7) as described above and the adhesion strength was evaluated by the following criteria.

adhesion strength is 60 N/10 mm or higher: SS
adhesion strength is at least 40 N/10 mm and less than 60 N/10 mm: S
adhesion strength is at least 30 N/10 mm and less than 40 N/10 mm: A
adhesion strength is at least 20 N/10 mm and less than 30 N/10 mm: B
adhesion strength is less than 20 N/10 mm: C
adhesion strength is not determined due to the sheet breakage: D
"SS" to "B" are acceptable, and "SS" is excellent.

(9) UV resistance

The b value measured from the P1 layer side of the laminate sheet before the UV treatment was designated K0, and the b value measured from the P1 layer side of the laminate sheet after the UV treatment was designated K, and the value calculated by the following equation (5):

$$\Delta b = K - K0 \ ... \ (5)$$

was used for the change in the color tone $\Delta b$ on the side of P1 layer. The UV resistance of the laminate sheet was evaluated by this value.

The UV treatment was conducted by Xenon Weather Meter SC750 manufactured by Suga Test Instruments Co., Ltd. under the conditions including a temperature of 65°C and a relative humidity of 50%, at an intensity of 150 W/m$^2$ (light source, xenon lamp; wavelength range, 290 to 400 nm), the side of the P1 layer was irradiated for 1000 hours. The b value of the P1 layer was determined by using spectrophotometer SE-2000 (manufactured by Nippon Denshoku Industries Co., Ltd.) according to JIS Z-8722 (2000) in reflection mode. The number of samples was 5, and the sample diameter was 30 mm. The b value of the samples was measured and the average was calculated. By using the thus obtained change in the color tone $\Delta b$ of the P1 layer side, the UV resistance of the laminate sheet was evaluated by the following criteria.

change in the color tone $\Delta b$ is up to 3: S
change in the color tone $\Delta b$ is more than 3 and up to 6: A
change in the color tone $\Delta b$ is more than 6 and up to 10: B
change in the color tone $\Delta b$ is more than 10: C
"S" to "B" are acceptable, and "S" is excellent.

(10) Average relative reflectance

Spectral reflectance in the range of 400 to 700 nm was measured at an interval of 10 nm by using spectrophotometer U-3410 (manufactured by Hitachi, Ltd.), and the average was used for the average relative reflectance. The number of samples was 5, and the average relative reflectance of each sample was measured to obtain the average. The measurement unit was an integrating sphere (No. 130-0632) having a diameter of 60 mm equipped with a spacer at an angle of 10°, and aluminum oxide (No. 210-0740) was used for the white standard. In the case of the laminate sheet, the measurement was conducted from the polyester resin layer side of the laminate sheet.

average relative reflectance is at least 80%: S
average relative reflectance is at least 60% and less than 80%: A
average relative reflectance is at least 30% and less than 60%: B
average relative reflectance is less than 30%: C
"S" to "B" are acceptable, and "S" is excellent.

(11) Partial discharge voltage

The partial discharge voltage was measured by using a partial discharge tester KPD2050 (manufactured by Kikusui Electronics Corporation). The test conditions were as described below.

- In the output sheet, the output voltage application pattern selected is the one comprising 3 stages, namely, the first stage of simply elevating the voltage from 0 V to the predetermined test voltage, the second stage of retaining the predetermined test voltage, and the third stage of simple voltage reduction pattern from the predetermined test voltage to 0 V.

- The frequency was 50 Hz, and the test voltage was 1 kV.
- The time T1 of the first stage was 10 sec, the time T2 of the second stage was 2 sec, and the time T3 of the third stage was 10 sec.
- In the pulse count sheet, set the [Count method] to "Plus [+]", and [Threshold level] to 50%.
- In the range sheet, set charge measurement range to 1000 pc.
- In the protection sheet, check the [Voltage] checkbox, and set the voltage at 2 kV. The pulse count is at 100,000.

Initial voltage in the measurement mode is 1.0 pc, and extinction voltage is 1.0 pc.

The measurement was carried out at any 10 locations in the film surface, and the average was calculated to determine the partial discharge voltage V0. The sample measured was the one which had been allowed to stand overnight in the room at a temperature of 23°C and a relative humidity of 65%.

partial discharge voltage is at least 950 V: S
partial discharge voltage is at least 700 V and less than 950 V: A
partial discharge voltage is at least 300 V and less than 700 V: B
partial discharge voltage is less than 300 V: C
"S" to "B" are acceptable, and "S" is excellent.

(12) Number average molecular weight

The number average molecular weight is the value determined by gel permeation chromatography by preparing a molecular weight calibration curve using PET-DMT (standard), and obtaining the number average molecular weight from this curve. The measurement was conducted at room temperature (23°C) by using a gel permeation chromatograph GCP-244 manufactured by Waters Corporation equipped with two columns (Shodex HFIP 80 M manufactured by Showa Denko) and a detector (Model R-401 differential refractometer manufactured by Waters Corporation) and using PET-DMT (standard). A calibration curve was depicted from the thus obtained elution volume (V) and molecular weight (M) by calculating coefficient ($A_1$) of the cubic approximate expression of the following equation (6).

$$Log(M) = A_0 + A_1V + A_2V^2 + A_2V^2 + A_3V^3 \ ... \ (6)$$

Next, a 0.06% by weight solution of polyester was prepared by using hexafluoropropanol (0.005 N sodium trifluoroacetate) for the solvent, and the measurement by GPC was conducted by using this solution under the conditions of the injection volume of 0.300 ml and the flow rate of 0.5 ml/min. The thus obtained elution-base molecular weight curve was overlaid with the molecular weight calibration curve to determine the molecular weight corresponding to each elution time zone, and the number average molecular weight was calculated by the following equation (7):

$$\text{Number average molecular weight (Mn)} = \Sigma N_iM_i/\Sigma N_i \quad ... \ (7)$$

wherein Ni is molar fraction, and Mi is the molecular weight at each elution position of the GPC curve obtained from the molecular weight calibration curve. It is to be noted that, when the polyester layer used for the measurement contained any of organic fine particles, inorganic fine particles, metal, metal salts, and other additives which are insoluble in the solvent, the insoluble contents were removed by filtration using a filter, centrifugation, or the like and a new solution was prepared before conducing the measurement. When additives such as plasticizer, surfactant, or dye may have been added to the polyester layer, the insoluble additives were also removed by reprecipitation, recrystallization, chromatography, extraction, or the like after removing the removal of the insoluble contents, and a new solution was prepared before conducing the measurement. When the polyester layer had a laminate structure, the polyester layer solely comprising the polyester layer was prepared by peeling other layers off the sample or by grinding other layers under microscope, and the molecular weight was determined by using the resulting sample solely comprising the polyester layer.

(13) Small endothermic peak temperature Tmeta before the melting peak and melting point Tm

The Small endothermic peak temperature Tmeta before the melting peak and the melting point Tm are values obtained in differential scanning calorimetry (hereinafter abbreviated as DSC) in the temperature elevation stage (temperature elevation rate, 20°C/min) according to the method based on JIS K-7121(1999). The temperature of the small endothermic peak before the crystal melting peak in the differential scanning calorimetric chart obtained by elevating the temperature from 25°C to 300°C at a temperature elevation rate of 20°C/min is designated Tmeta, and the peak top temperature of the crystal melting peak in the differential scanning calorimetric chart obtained by retaining the temperature at 300°C for 5 minutes and subsequently quenching to 25°C, and elevating the temperature again from 25°C to 300°C at a temperature elevation rate of 20°C/min is designated Tm.

(14) Processibility

A solar cell module was produced by stacking components in the order of [the transparent substrate / the first sealant / the photovoltaic element / the second sealant / the laminate sheet] and conducting the lamination in a vacuum laminator. 100 solar cell modules were produced under the lamination conditions of 150°C, vacuum period of 5 minutes, and press period of 10 minutes, and processibility in the production process of the solar cell module was evaluated by the following criteria.

    95 or more solar cell modules were acceptable: S
    90 to 94 solar cell modules were acceptable: A
    80 to 89 solar cell modules were acceptable: B
    up to 79 solar cell modules were acceptable: C
    "S" to "B" are acceptable, and "S" is excellent.

(15) Intrinsic Viscosity IV

The P1 layer was dissolved in 100 ml of o-chlorophenol (concentration C of the solution = 1.2 g/ml), and the solution was evaluated for its viscosity at 25°C by Ostwald viscometer. The solvent was also evaluated for its viscosity. The thus obtained viscosity of the solution and the solvent were used for the calculation of the $[\eta]$ by the following equation (8), and the $[\eta]$ was used for the intrinsic viscosity (IV).

$$\eta_{sp}/C = [\eta] + K[\eta]^{2 \cdot} C \qquad ... (8)$$

(wherein $\eta_{sp}$ = (viscosity of the solution / viscosity of the solvent) - 1, and K is Huggins' constant (which is 0.343 in this case)).

(16) Amount of the terminal COOH

Amount of the terminal COOH in the P1 layer was measured by the method of Maulice (see M.J. Maulice, F. Huizinga, Anal.Chim.Acta,22 363(1960))

[Examples]

Next, the present invention is described by referring to Examples which by no means limit the scope of the invention.

(Polyester resin material)

1. PET-A material (Examples 1 to 7 and 10 to 35 and Comparative Examples 1 to 3, and 5 to 10)
Polycondensation was conducted by using 100% by mole of terephthalic acid for the dicarboxylic acid component, 100% by mole of ethylene glycol for the diol component, and magnesium acetate, antimony trioxide, and phosphorous acid for the catalysts. Next, the resulting polyethylene terephthalate was dried at 160°C for 6 hours for crystallization, and solid phase polymerization was conducted at a temperature of 220°C and a degree of vacuum of 0.3 Torr for 9 hours to produce polyethylene terephthalate (PET-A) material having a melting point of 255°C, an intrinsic viscosity of 0.80, and a terminal COOH group amount of 10 eq./t.

2. PET-B material (Example 36)

Polycondensation was conducted by using 100% by mole of terephthalic acid for the dicarboxylic acid component, 100% by mole of ethyleneglycol for the diol component, and magnesium acetate, antimony trioxide, and phosphorous acid for the catalysts. Next, the resulting polyethylene terephthalate was dried at 160°C for 6 hours for crystallization. The resulting polyethylene terephthalate (PET-B) material had a melting point of 255°C, an intrinsic viscosity of 0.65, and a terminal COOH group amount of 25 eq./t.

3. PET-C material (Example 37)

Polycondensation was conducted by using 100% by mole of terephthalic acid for the dicarboxylic acid component, 100% by mole of ethylene glycol for the diol component, and magnesium acetate, antimony trioxide, and phosphorous acid for the catalysts. Next, the resulting polyethylene terephthalate was dried at 160°C for 6 hours for crystallization, and solid phase polymerization was conducted at 220°C and a degree of vacuum of 0.3 Torr for 12 hours to produce polyethylene terephthalate (PET-C) material having a melting point of 255°C, an intrinsic viscosity of 1.18, and a terminal COOH group amount of 15 eq./t.

4. PEN material (Example 8)

0.03 parts by weight of manganese acetate tetrahydrate salt was added to a mixture of 100 parts by weight of dimethyl 2,6-naphthalene dicarboxylate and 60 parts by weight of ethylene glycol, and transesterification was conducted by gradually elevating the temperature from 150°C to 240°C. In the course of this transesterification, 0.024 parts by weight of antimony trioxide was added when the reaction temperature reached 170°C, and 0.042 parts by weight (corresponding to 2m% by mole) of tetrabutylphosphonium 3,5-dicarboxybenzenesulfonate was added when the reaction temperature reached 220°C. The transesterification was further continued, and 0.023 parts by weight of trimethyl phosphoric acid was added. The reaction product was then transferred to a polymerization reactor, and the temperature was elevated to 290°C, and the polycondensation was conducted by reducing the pressure to the level of as low as 30 Pa until the agitation torque of the polymerization reactor was at the predetermined value (the agitation torque of polyethylene-2,6-naphthalate having an intrinsic viscosity of 0.65 in this polymerization reactor was used for the predetermined value while this value may differ by the specification of the polymerization reactor used). Next, the resulting polyethylene terephthalate was dried at 160°C for 6 hours for crystallization, and solid phase polymerization was conducted at 220°C and a degree of vacuum of 0.3 Torr for 9 hours to produce polyethylene naphthalate (PEN) material having a melting point of 255°C, an intrinsic viscosity of 0.70, and a terminal COOH group amount of 25 eq./t.

5. PBT material (Example 9)

Toraycon 1200M manufactured by Toray Industries, Inc. was used. The Toraycon 1200M had a melting point of 255°C, an intrinsic viscosity of 1.23, and a terminal COOH group of 23 eq./t.

6. PET base titanium oxide master A (Examples 1 to 7, Examples 11 to 35, and Comparative Examples 5 to 10 )

100 parts by weight of the PET-A material obtained in the above "1" and 100 parts by weight of rutile type titanium oxide particles having an average particle diameter of 210 nm were melt kneaded in a vented extruder at 290°C to prepare titanium oxide material (PETa-TiO$_2$).

7. PET base titanium oxide master B (Example 36)

100 parts by weight of the PET-B material obtained in the above "2" and 100 parts by weight of rutile type titanium oxide particles having an average particle diameter of 210 nm were melt kneaded in a vented extruder at 290°C to prepare titanium oxide material (PETb-TiO$_2$).

8. PET base titanium oxide master C (Example 37)

100 parts by weight of the PET-C material obtained in the above "3" and 100 parts by weight of rutile type titanium oxide particles having an average particle diameter of 210 nm were melt kneaded in a vented extruder at 290°C to prepare titanium oxide material (PETc-TiO$_2$).

9. PEN base titanium oxide master (Example 8)

100 parts by weight of the PEN material obtained in the above "4" and 100 parts by weight of rutile type titanium oxide particles having an average particle diameter of 210 nm were melt kneaded in a vented extruder at 300°C to prepare titanium oxide material (PEN-TiO$_2$).

10. PBT base titanium oxide master (Example 9)

100 parts by weight of the PBT material obtained in the above "5" and 100 parts by weight of rutile type titanium oxide particles having an average particle diameter of 210 nm were melt kneaded in a vented extruder at 260°C to prepare titanium oxide material ($PBT-TiO_2$).

(Preparation of the coating compositions used for the adhesive layer)

1. Coating composition A (Examples 1 to 13 and 19 to 37 and Comparative Example 2 and 5 to 10)

50% by weight of an aqueous dispersion of maleic anhydride-modified polypropylene (maleic anhydride-modified PP) resin, 48% by weight of a water-base polyurethane resin coating composition, 2% by weight of an epoxy crosslinking agent, and 0.2% by weight of a fluorosurfactant ,and PLAS COAT RY-2 manufactured by Goo Chemical Co.,Ltd. at the ratio of the solid content were blended by using water for the dilution solvent to prepare an emulsion having a solid content of 15% by weight.

2. Coating composition B (Example 14)

96% by weight of a water-base polyurethane resin coating composition, 4% by weight of an epoxy crosslinking agent, and 0.2% by weight of a fluorosurfactant ,and PLAS COAT RY-2 manufactured by Goo Chemical Co.,Ltd. at the ratio of the solid content were blended by using water for the dilution solvent to prepare an emulsion having a solid content of 15% by weight.

3. Coating composition C (Example 15)

5% by weight of an aqueous dispersion of maleic anhydride-modified polypropylene (maleic anhydride-modified PP) resin, 93% by weight of a water-base polyurethane resin coating composition, 2% by weight of an epoxy crosslinking agent, and 0.2% by weight of a fluorosurfactant ,and PLAS COAT RY-2 manufactured by Goo Chemical Co.,Ltd. at the ratio of the solid content were blended by using water for the dilution solvent to prepare an emulsion having a solid content of 15% by weight.

4. Coating composition D (Example 16)

The procedure of preparing the coating composition C was repeated except that 50% by weight of an aqueous dispersion of maleic anhydride-modified polypropylene (maleic anhydride-modified PP) resin, 50% by weight of a water-base polyurethane resin coating composition, and 0.2% by weight of a fluorosurfactant (PLAS COAT RY-2 manufactured by Goo Chemical Co.,Ltd.) were blended to thereby prepare an emulsion having a solid content of 15% by weight.

5. Coating composition E (Example 17)

The procedure of preparing the coating composition C was repeated except that 88% by weight of an aqueous dispersion of maleic anhydride-modified polypropylene (maleic anhydride-modified PP) resin, 10% by weight of a water-base polyurethane resin coating composition, 2% by weight of an epoxy crosslinking agent, and 0.2% by weight of a fluorosurfactant, and (PLAS COAT RY-2 manufactured by Goo Chemical Co.,Ltd. were blended to thereby prepare an emulsion having a solid content of 15% by weight.

6. Coating composition F (Example 18)

The procedure of preparing the coating composition C was repeated except that 89% by weight of an aqueous dispersion of maleic anhydride-modified polypropylene (maleic anhydride-modified PP) resin, 9% by weight of a water-base polyurethane resin coating composition, 2% by weight of an epoxy crosslinking agent, and 0.2% by weight of a fluorosurfactant, and PLAS COAT RY-2 manufactured by Goo Chemical Co.,Ltd. were blended to thereby prepare an emulsion having a solid content of 15% by weight.

(Olefin material)

1. EPBC (P31 layer in Examples 1 to 19 and 22 to 37, and Comparative Examples 3 to 10; P32 layer in Examples 20 to 21; and P33 layer in Example 23 and Example 35)

An EPBC was prepared by copolymerization using 3.5% by weight of ethylene and 4.0% by weight of butane. The EPBC had a melting point (hereinafter abbreviated as Tm) of 160°C and a melt flow rate at 230°C (hereinafter abbreviated as MFR) of 6 g/10 min.

2. PP (P32 layer in Examples 1 to 19, Examples 22 to 24, Examples 27 to 37, and Comparative Examples 5 to 10)

Ahomo-PP having a Tm of 165°C and a MFR at 230°C of 7 g/10 min was used.

3. EPC (P33 layer in Examples 1 to 20, Example 22, Examples 24 to 34, Example 37, and Comparative Examples 5 to 10; and P31 layer in Example 19)

An EPC was prepared by copolymerization using 4.2% by weight of ethylene, and the EPC had a Tm of 142°C and a MFR at 230°C of 6 g/10 min.

4. LLDPE (P33 layer in Examples 1 to 20, Example 22, Examples 24 to 34, and Example 37 and Comparative Examples 5 to 10; and P31 layer in Example 19)

An LLDPE having a Tm of 115°C and a MFR at 190°C of 3 g/10 min was used.

5. Polyolefin elastomer A (Example 24)

A non-crosslinked elastomer resin having a Tm of 160°C, a MFR at 230°C of 6 g/10 min, and a density of 0.9 $kg/m^3$ was used.

6. Polyolefin elastomer B (P31 layer in Examples 34 to 35 and P33 layer in Example 35)

An olefin elastomer resin having a Tm of 59°C, a MFR at 190°C of 5.0 dg/min, and a density of 0.87 $kg/m^3$ was used.

7. Acid-modified olefin (Example 22)

An acid-modified olefin resin having a Tm of 120°C, a MFR at 190°C of 3.5 g/10 min, and a density of 0.9 $g/m^3$ was used.

8. PP base titanium oxide master (Examples 1 to 19, Examples 22 to 24, Examples 27 to 37, and Comparative Examples 5 to 10)

100 parts by weight of the PP resin and 100 parts by weight of the rutile type titanium oxide particles having an average particle diameter of 210 nm were melt kneaded in a vented extruder at 300°C to prepare titanium oxide material (PP-$TiO_2$).

9.EPBC base titanium oxide master (Example 20, Example 21, and Example 25)

100 parts by weight of the EPBC resin and 100 parts by weight of the rutile type titanium oxide particles having an average particle diameter of 210 nm were melt kneaded in a vented extruder at 300°C to prepare titanium oxide material (EPBC-$TiO_2$).

(Examples 1 to 2, 4 to 7, 10 to 19, 22 to 25, and 27 to 35 and Comparative Examples 5 to 10)

The "PET-A material" and the "PET base titanium oxide master A" described in the section of the "(Polyester resin material)" which had been dried in vacuum at 180°C for 2 hours were mixed so that the mixture had the concentration as indicated in the Table 1, and the mixture was melt kneaded in an extruder at 290°C. The mixture was then introduced in a T die nozzle, and melt extruded into a sheet from the T die nozzle. The sheet was electrostatically attached and cooled on a drum having the surface temperature maintained at 25°C for solidification to thereby obtain an unstretched monolayer film. Subsequently, the unstreched monolayer film was preliminarily heated on rolls which had been heated to a temperature of 80°C, and stretched 3.3 times in axial (machine) direction by using a roll which had been heated to a temperature of 85°C. The film was then cooled on rolls maintained at a temperature of 25°C to obtain a uniaxially stretched film. The uniaxially stretched film was subjected to corona treatment, and then, the coating composition corresponding to the number of the Example and Comparative Example in the coating compositions described in the section of the "(Preparation of the coating compositions used for the adhesive layer)" was coated by #8 metering bar.

The resulting uniaxially stretched film was guided to preheating zone at a temperature of 90°C in the tenter with its opposite edges held by clips, and subsequently, the sheet was stretched in the heating zone maintained at 100°C at a direction 3.8 times in the direction perpendicular to the axial direction (transverse direction), and further was heat set in the heat treatment zone in the tenter at 200°C for 20 seconds. The sheet was then relaxed (4%) in transverse direction at 210°C, and then, uniformly and gradually cooled to obtain a biaxially stretched film. The film thickness, the intrinsic viscosity IV, and the content of the terminal COOH group of the P1 layer and the thickness of the adhesive layer P2 were as shown in Table 1.

Next, the laminate sheet was extruded by using extruder 1, extruder 2, and extruder 3. Each of the composition to be extruded from the extruder was melt kneaded in the extruder at 300°C by using each of the olefin materials described in the section of the "(Olefin material)" so that the composition of the P31 layer, the P32 layer, and the P33 layer were as shown in Table 1. The compositions were brought together by using a multimanifold so that they were laminated in the order of P31 layer / P32 layer / P33 layer at a laminating ratio of 1 / 4 / 1 in this order. Immediately after the casting of the resin extrudate from the nozzle on a drum having the surface temperature maintained at 15°C, the surface of the adhesive layer of the biaxially stretched PET film was brought in pressing contact with the extrudate to prepare a laminate sheet having the constitution of Table 1.

The resulting laminate sheets were evaluated for their properties, and as shown in Table 2, the sheets obtained were excellent in various properties including the surface flatness and interlayer adhesion.

Example 2 had thin P2 layer, and accordingly, the interlayer adhesion was slightly inferior.

Example 4 had a small thickness ratio P1/P3, and accordingly, the surface flatness was slightly inferior.

Example 5 had a large thickness ratio P1/P3, and accordingly, the water vapor permeability was slightly inferior.

Example 6 had a small total thickness, and the water vapor permeability and the partial discharge voltage were slightly inferior.

Example 7 had a large total thickness, and the processibility was slightly inferior.

Example 10 did not contain titanium oxide in the P1 layer, and therefore, UV resistance was inferior.

The titanium oxide concentration of the P1 layer was changed in Examples 11 to 14, and accordingly, the UV resistance and the initial interlayer adhesion were slightly inferior.

Example 15 had a small W2a/W2b ratio of the P2 layer, and accordingly, evaluation of the initial interlayer adhesion was "A".

Example 16 did not contain any crosslinking agent (epoxy) in the P2 layer, and accordingly, interlayer adhesion after the wet heat resistance test was slightly inferior.

Examples 17 and 18 had a large W2a/W2b ratio of the P2 layer, and accordingly, evaluation of the initial interlayer adhesion was "A" or "B".

The type of the olefin in the P3 layer was changed in Example 19, and accordingly, evaluation of the initial interlayer adhesion was "A".

The type of the olefin in the P3 layer was changed in Examples 22 to 25 and Examples 34 to 35, and accordingly, the properties were equivalent or superior to Example 1.

Concentration of the titanium oxide in the P3 layer was changed in Examples 27 to 29, and accordingly, the average relative reflectance or the adhesion strength with the EVA was slightly inferior.

The thickness of the P1 layer was changed in Examples 30 to 33, and accordingly, the water vapor permeability and the processibility were slightly inferior in some Examples.

Comparative Example 5 had a small P2 layer thickness and inferior initial interlayer adhesion.

Comparative Example 6 had a large P2 layer thickness and inferior initial interlayer adhesion.

Comparative Example 7 had a small thickness ratio P1/P3, and accordingly, interior surface flatness.

Comparative Example 8 had a large thickness ratio P1/P3, and accordingly, inferior water vapor permeability.

Comparative Example 9 had a small total thickness and inferior water vapor permeability and partial discharge voltage.

Comparative Example 10 had a large total thickness and inferior processibility.

(Example 3) The "PET-A material" and the "PET base titanium oxide master A" described in the section of the "(Polyester resin material)" which had been dried in vacuum at 180°C for 2 hours were mixed so that the mixture had the concentration as indicated in the Table 1, and the mixture was melt kneaded in an extruder at 290°C. The mixture was then introduced in a T die nozzle, and melt extruded into a sheet from the T die nozzle. The sheet was electrostatically attached and cooled on a drum having the surface temperature maintained at 25°C for solidification to thereby obtain an unstreched monolayer film. Subsequently, the unstreched monolayer film was preliminarily heated on rolls which had been heated to a temperature of 80°C, and stretched 3.3 times in axial (machine) direction by using a roll which had been heated to a temperature of 85°C. The film was then cooled on rolls maintained at a temperature of 25°C to obtain a uniaxially stretched film. The resulting uniaxially stretched film was guided to preheating zone at a temperature of 90°C in the tenter with its opposite edges held by clips, and subsequently, the sheet was stretched 3.8 times in the heating zone maintained at 100°C in the direction perpendicular to the axial direction (transverse direction), and further was heat set in the heat treatment zone in the tenter at 200°C for 20 seconds. The sheet was then relaxed (4%) in transverse direction at 210°C, and then, uniformly and gradually cooled to obtain a biaxially stretched film having a thickness of 150 μm. The intrinsic viscosity IV, and the content of the terminal COOH group of the P1 layer were as shown in Table 1.

The coating composition A was coated on one surface of the film obtained in the procedure as described above under the coating conditions as described below by using a gravure coater to provide the adhesive layer.

Coating conditions: dried film thickness, 3.0 μm; drying oven temperature, 120°C

Aging: after the coating and winding, the film was aged in the chamber at 40°C for 2 days.

Next, the laminate sheet was extruded by using extruder 1, extruder 2, and extruder 3. Each of the composition to be extruded from the extruder was melt kneaded in the extruder at 300°C by using each of the olefin materials described in the section of the "(Olefin material)" so that the composition of the P31 layer, the P32 layer, and the P33 layer were as shown in Table 1. The compositions were brought together by using a multimanifold so that they were laminated in the order of P31 layer / P32 layer / P33 layer at a laminating ratio of 1 / 4 / 1 in this order. Immediately after the casting of the resin extrudate from the nozzle on a drum having the surface temperature maintained at 15°C, the surface of the adhesive layer of the biaxially stretched PET film is brought in pressing contact with the extrudate to prepare a laminate sheet having the constitution of Table 1.

The resulting laminate sheets were evaluated for their properties, and as shown in Table 2, the sheets obtained had a thick P2 layer, and interlayer adhesion was slightly inferior.

(Example 8)

The "PEN material" and the "PEN base titanium oxide master" described in the section of the "(Polyester resin material)" which had been dried in vacuum at 180°C for 2 hours were mixed so that the mixture had the concentration as indicated in the Table 1, and the mixture was melt kneaded in an extruder at 300°C. The mixture was then introduced in a T die nozzle, and melt extruded into a sheet from the T die nozzle. The sheet was electrostatically attached and cooled on a drum having the surface temperature maintained at 25°C for solidification to thereby obtain an unstreched monolayer film. Subsequently, the unstreched monolayer film was preliminarily heated on rolls which had been heated to a temperature of 130°C, and stretched 4.2 times in axial (machine) direction by using a roll which had been heated to a temperature of 145°C. The film was then cooled on rolls maintained at a temperature of 25°C to obtain a uniaxially stretched film. The uniaxially stretched film was subjected to corona treatment, and then, the coating composition A was coated by #8 metering bar.

The procedure of Example 1 was repeated except that the resulting uniaxially stretched film was guided to preheating zone at a temperature of 135°C in the tenter with its opposite edges held by clips, and subsequently, the sheet was stretched 4.5 times in the heating zone maintained at 145°C in the direction perpendicular to the axial direction (transverse direction), and further was heat set in the heat treatment zone in the tenter at 200°C for 20 seconds. The sheet was then relaxed (4%) in transverse direction at 210°C, and subsequently, uniformly and gradually cooled to obtain a biaxially stretched film. The film thickness, the intrinsic viscosity IV, and the content of the terminal COOH group of the P1 layer and the thickness of the adhesive layer P2 were as shown in Table 1. The resulting laminate sheets were evaluated for their properties, and as shown in Table 2, the sheets obtained were excellent in various properties including the surface flatness.

(Example 9)

The procedure of Example 1 was repeated except that the "PBT material" and the "PBT base titanium oxide master" described in the section of the "(Polyester resin material)" which had been dried in vacuum at 180°C for 2 hours were mixed so that the mixture had the concentration as indicated in the Table 1, and the mixture was melt kneaded in an extruder at 260°C. The mixture was then introduced in a T die nozzle, and melt extruded into a sheet from the T die nozzle. The sheet was electrostatically attached and cooled on a drum having the surface temperature maintained at 25°C for solidification to thereby obtain an unstreched monolayer film having a thickness of 150 μm. The coating composition A was coated on one surface of the film obtained in the procedure as described above under the coating conditions as described below by using a gravure coater to provide the adhesive layer.

Coating conditions: dried film thickness, 0.4 μm; drying oven temperature, 120°C

Aging: after the coating and winding, the film was aged in the chamber at 40°C for 2 days.
The resulting laminate sheets were evaluated for their properties, and as shown in Table 2, the sheets obtained were excellent in various properties including the surface flatness.

(Example 20)

The procedure of Example 1 was repeated except that, the extruders 1 and 2 were used in the step of P3 layer. The "EPBC" and the "EPBC base titanium oxide master" described in the section of "(Olefin material)" which would be the P32 layer were introduced in the extruder 1 so that the composition of the P32 layer would be as shown in Table 1, and the "EPC" and the "LLDPE" described in the section of "(Olefin material)" which would be the P33 layer were introduced in the extruder 2 so that the composition of the P33 layer would be as shown in Table 1, and the melt kneading was conducted in each extruder at 300°C and extraction from the nozzle was conducted so that the thickness ratio was 4/1 in this order. The resulting laminate sheets were evaluated for their properties, and as shown in Table 2, the laminate sheet was somewhat inferior in the interlayer adhesion and the adhesion strength with the filler due to the change of the olefin used for the P3 layer.

(Example 21)

The procedure of Example 1 was repeated except that, in the step of P3 layer, the extruders 1 was used, the "EPBC" and the "EPBC base titanium oxide master" described in the section of "(Olefin material)" were introduced in the extruder so that the composition of the P32 layer would be as shown in Table 1, and the components were melt kneading in the extruder at 300°C and extruded from the nozzle. The resulting laminate sheets were evaluated for their properties, and as shown in Table 2, the laminate sheet was somewhat inferior in the interlayer adhesion and the adhesion strength with EVA due to the change of the olefin used for the P3 layer.

(Example 26)

The procedure of Example 1 was repeated except that the extruders 1 and 2 were used in the step of P3 layer. The "EPBC" described in the section of "(Olefin material)" which would be the P31 layer was introduced in the extruder 1, and the "EPC" and the "LLDPE" described in the section of "(Olefin material)" which would be the P33 layer were introduced in the extruder 2 so that the composition of the P33 layer would be as shown in Table 1, and the melt kneading was conducted in each extruder at 300°C and extraction from the nozzle was conducted so that the thickness ratio was 1/1 in this order. The resulting laminate sheets were evaluated for their properties, and as shown in Table 2, evaluation of the laminate sheet for the average relative reflectance was "A" due to the change of the titanium oxide concentration in the P3 layer.

(Example 36)

The procedure of Example 1 was repeated except that, the "PET-B material" and the "PET base titanium oxide master B" described in the section of "(Polyester resin material)" which had been dried in vacuum at 180°C for 2 hours were blended at the concentration of Table 1 to thereby produce the laminate sheet having the constitution of Table 1. The resulting laminate sheets were evaluated for their properties, and as shown in Table 2, due to the change of the intrinsic viscosity IV and amount of the COOH terminal group in the P1 layer, the adhesion strength was immeasurable because of the breakage of the P1 layer in the interlayer adhesion test after the wet heat resistance test and in the EVA adhesion test after the wet heat resistance test while the adhesion strength was acceptable as long as the P1 layer was not broken.

(Example 37)

The procedure of Example 1 was repeated except that, in the step of P1 layer, the "PET-C material" and the "PET base titanium oxide master C" described in the section of "(Polyester resin material)" which had been dried in vacuum at 180°C for 2 hours was blended at the concentration of Table 1 to thereby produce the laminate sheet having the constitution of Table 1. Because of the high intrinsic viscosity IV of the PET material constituting the P1 layer, the extrusion pressure of the extruder increased in the step of the P1 layer formation, and the film stretchability and surface flatness were sacrificed. The resulting laminate sheet was evaluated for the properties, and due to the poor surface flatness of the P1 layer, the interlayer adhesion was slightly inferior.

(Comparative Example 1)

The "PET-A material" described in the section of the "(Polyester resin material)" which had been dried in vacuum at 180°C for 2 hours were mixed, and the mixture was melt kneaded in an extruder at 290°C. The mixture was then introduced in a T die nozzle, and melt extruded into a sheet from the T die nozzle. The sheet was electrostatically attached and cooled on a drum having the surface temperature maintained at 25°C for solidification to thereby obtain an unstreched monolayer film. Subsequently, the unstreched monolayer film was preliminarily heated on rolls which had been heated to a temperature of 80°C, and stretched 3.3 times in axial (machine) direction by using a roll which had been heated to a temperature of 85°C. The film was then cooled on rolls maintained at a temperature of 25°C to obtain a uniaxially stretched film. The resulting uniaxially stretched film was guided to preheating zone at a temperature of 90°C in the tenter with its opposite edges held by clips, and subsequently, the sheet was stretched in the heating zone maintained at 100°C at a direction 3.8 times in the direction perpendicular to the axial direction (transverse direction), and further was heat set in the heat treatment zone in the tenter at 200°C for 20 seconds. The sheet was then relaxed (4%) in transverse direction at 210°C, and then, uniformly and gradually cooled to obtain a biaxially stretched film having a thickness of 150 μm. The film thickness, the intrinsic viscosity IV, and the content of the terminal COOH group of the P1 layer, and the thickness of the adhesive layer P2 were as shown in Table 1. The resulting laminate sheet was evaluated for the properties, and as shown in Table 2, the sheet obtained was inferior in the water vapor permeability and other properties.

(Comparative Example 2)

The "PET-A material" described in the section of the "(Polyester resin material)" which had been dried in vacuum at 180°C for 2 hours were melt kneaded in an extruder at 290°C. The mixture was then introduced in a T die nozzle, and melt extruded into a sheet from the T die nozzle. The sheet was electrostatically attached and cooled on a drum having the surface temperature maintained at 25°C for solidification to thereby obtain an unstreched monolayer film. Subsequently, the unstreched monolayer film was preliminarily heated on rolls which had been heated to a temperature of 80°C, and stretched 3.3 times in axial (machine) direction by using a roll which had been heated to a temperature of 85°C. The film was then cooled on rolls maintained at a temperature of 25°C to obtain a uniaxially stretched film. The uniaxially stretched film was subjected to corona treatment, and then, the coating composition A was coated by #8 metering bar.

The resulting uniaxially stretched film was guided to preheating zone at a temperature of 90°C in the tenter with its opposite edges held by clips, and subsequently, the sheet was stretched 3.8 times in the heating zone maintained at 100°C in the direction perpendicular to the axial direction (transverse direction), and further was heat set in the heat treatment zone in the tenter at 200°C for 20 seconds. The sheet was then relaxed (4%) in transverse direction at 210°C, and then, uniformly and gradually cooled to obtain a biaxially stretched film having a P1 layer with the thickness of 150 μm and a P2 layer (adhesive layer) with the thickness of 0.4 μm. The resulting laminate sheet was evaluated for the properties, and as shown in Table 2, the sheet obtained was inferior in the water vapor permeability and other properties.

(Comparative Example 3)

The "PET-A material" described in the section of the "(Polyester resin material)" which had been dried in vacuum at 180°C for 2 hours were melt kneaded in an extruder at 290°C. The mixture was then introduced in a T die nozzle, and melt extruded into a sheet from the T die nozzle. The sheet was electrostatically attached and cooled on a drum having the surface temperature maintained at 25°C for solidification to thereby obtain an unstreched monolayer film. Subsequently, the unstreched monolayer film was preliminarily heated on rolls which had been heated to a temperature of 80°C, and stretched 3.3 times in axial (machine) direction by using a roll which had been heated to a temperature of 85°C. The film was then cooled on rolls maintained at a temperature of 25°C to obtain a uniaxially stretched film. The resulting uniaxially stretched film was guided to preheating zone at a temperature of 90°C in the tenter with its opposite edges held by clips, and subsequently, the sheet was stretched 3.8 times in the heating zone maintained at 100°C in the direction perpendicular to the axial direction (transverse direction), and further was heat set in the tenter at 200°C for 20 seconds. The sheet was then relaxed (4%) in transverse direction at 210°C, and then uniformly and gradually cooled to obtain a biaxially stretched film having a thickness of 150 μm.

Next, the laminate sheet was extruded by using the extruder 1. The resin of the P31 layer shown in Table 1 was melt kneaded in the extruder at 300°C. Immediately after the casting of the resin extrudate from the nozzle on a drum having the surface temperature maintained at 15°C, the surface of the adhesive layer of the biaxially stretched PET film was brought in pressing contact with the extrudate to prepare a laminate sheet having the constitution of Table 1. The resulting laminate sheet was evaluated for the properties, and as shown in Table 2, the sheet obtained was inferior in the initial interlayer adhesion and other properties.

(Comparative Example 4)

In the step of preparing the P3 layer, the resin of the P31 layer shown in Table 1 was melt kneaded in the extruder 1 at 300°C, the resin extrudate from the nozzle was cast on a drum having the surface temperature maintained at 15°C to prepare a sheet having the constitution of Table 1. The resulting sheet was evaluated for the properties, and as shown in Table 2, the sheet obtained was inferior in the UV resistance and other properties.

[Table 1-1-1]

| | P1 layer | | | | P2 layer | | | | | | W2a/W2b |
| | | | | | Modified olefin resin | | Main component | | Crosslinking agent | | |
| | Polyester | Content of TiO$_2$ particles % by wt | IV | Amount of COOH terminal group eq./t | Type | % by wt | Type | % by wt | Type | % by wt | |
|---|---|---|---|---|---|---|---|---|---|---|---|
| Ex. 1 | PET-A | 4 | 0.67 | 12.5 | Maleic anhydride-modified PP | 50 | Polyurethane resin | 48 | Epoxy | 2 | 1.0 |
| Ex. 2 | PET-A | 4 | 0.67 | 12.5 | Maleic anhydride-modified PP | 50 | Polyurethane resin | 48 | Epoxy | 2 | 1.0 |
| Ex. 3 | PET-A | 4 | 0.67 | 12.5 | Maleic anhydride-modified PP | 50 | Polyurethane resin | 48 | Epoxy | 2 | 1.0 |
| Ex. 4 | PET-A | 4 | 0.67 | 12.5 | Maleic anhydride-modified PP | 50 | Polyurethane resin | 48 | Epoxy | 2 | 1.0 |
| Ex. 5 | PET-A | 4 | 0.67 | 12.5 | Maleic anhydride-modified PP | 50 | Polyurethane resin | 48 | Epoxy | 2 | 1.0 |
| Ex. 6 | PET-A | 4 | 0.67 | 12.5 | Maleic anhydride-modified PP | 50 | Polyurethane resin | 48 | Epoxy | 2 | 1.0 |
| Ex. 7 | PET-A | 4 | 0.67 | 12.5 | Maleic anhydride-modified PP | 50 | Polyurethane resin | 48 | Epoxy | 2 | 1.0 |
| Ex. 8 | PEN | 4 | 0.65 | 28 | Maleic anhydride-modified PP | 50 | Polyurethane resin | 48 | Epoxy | 2 | 1.0 |
| Ex. 9 | PBT | 4 | 1.2 | 25 | Maleic anhydride-modified PP | 50 | Polyurethane resin | 48 | Epoxy | 2 | 1.0 |
| Ex. 10 | PET-A | 0 | 0.7 | 12 | Maleic anhydride-modified PP | 50 | Polyurethane resin | 48 | Epoxy | 2 | 1.0 |
| Ex. 11 | PET-A | 1 | 0.68 | 12.3 | Maleic anhydride-modified PP | 50 | Polyurethane resin | 48 | Epoxy | 2 | 1.0 |
| Ex. 12 | PET-A | 30 | 0.6 | 18 | Maleic anhydride-modified PP | 50 | Polyurethane resin | 48 | Epoxy | 2 | 1.0 |
| Ex. 13 | PET-A | 31 | 0.6 | 18 | Maleic anhydride-modified PP | 50 | Polyurethane resin | 48 | Epoxy | 2 | 1.0 |

(continued)

| | | P1 layer | | | P2 layer | | | | | | W2a/W2b |
|---|---|---|---|---|---|---|---|---|---|---|---|
| | | | | | Modified olefin resin | | Main component | | Crosslinking agent | | |
| | Polyester | Content of $TiO_2$ particles % by wt | IV | Amount of COOH terminal group eq./t | Type | % by wt | Type | % by wt | Type | % by wt | |
| Ex. 14 | PET-A | 4 | 0.67 | 12.5 | - | 0 | Polyurethane resin | 96 | Epoxy | 4 | 0.0 |
| Ex. 15 | PET-A | 4 | 0.67 | 12.5 | Maleic anhydride-modified PP | 5 | Polyurethane resin | 93 | Epoxy | 2 | 0.1 |
| Ex. 16 | PET-A | 4 | 0.67 | 12.5 | Maleic anhydride-modified PP | 50 | Polyurethane resin | 50 | - | 0 | 1.0 |
| Ex. 17 | PET-A | 4 | 0.67 | 12.5 | Maleic anhydride-modified PP | 88 | Polyurethane resin | 10 | Epoxy | 2 | 8.8 |
| Ex. 18 | PET-A | 4 | 0.67 | 12.5 | Maleic anhydride-modified PP | 89 | Polyurethane resin | 9 | Epoxy | 2 | 9.9 |
| Ex. 19 | PET-A | 4 | 0.67 | 12.5 | Maleic anhydride-modified PP | 50 | Polyurethane resin | 48 | Epoxy | 2 | 1.0 |
| Ex. 20 | PET-A | 4 | 0.67 | 12.5 | Maleic anhydride-modified PP | 50 | Polyurethane resin | 48 | Epoxy | 2 | 1.0 |
| Ex. 21 | PET-A | 4 | 0.67 | 12.5 | Maleic anhydride-modified PP | 50 | Polyurethane resin | 48 | Epoxy | 2 | 1.0 |
| Ex. 22 | PET-A | 4 | 0.67 | 12.5 | Maleic anhydride-modified PP | 50 | Polyurethane resin | 48 | Epoxy | 2 | 1.0 |
| Ex. 23 | PET-A | 4 | 0.67 | 12.5 | Maleic anhydride-modified PP | 50 | Polyurethane resin | 48 | Epoxy | 2 | 1.0 |
| Ex. 24 | PET-A | 4 | 0.67 | 12.5 | Maleic anhydride-modified PP | 50 | Polyurethane resin | 48 | Epoxy | 2 | 1.0 |

[Table 1-1-2]

| | P1 layer | | | | P2 layer | | | | | | W2a/W2b |
| | Polyester | Content of TiO$_2$ particles % by wt | IV | Amount of COOH terminal group eq./t | Modified olefin resin | | Main component | | Crosslinking agent | | |
| | | | | | Type | % by wt | Type | % by wt | Type | % by wt | |
| Ex. 25 | PET-A | 4 | 0.67 | 12.5 | Maleic anhydride-modified PP | 50 | Polyurethane resin | 48 | Epoxy | 2 | 1.0 |
| Ex. 26 | PET-A | 4 | 0.67 | 12.5 | Maleic anhydride-modified PP | 50 | Polyurethane resin | 48 | Epoxy | 2 | 1.0 |
| Ex. 27 | PET-A | 4 | 0.67 | 12.5 | Maleic anhydride-modified PP | 50 | Polyurethane resin | 48 | Epoxy | 2 | 1.0 |
| Ex. 28 | PET-A | 4 | 0.67 | 12.5 | Maleic anhydride-modified PP | 50 | Polyurethane resin | 48 | Epoxy | 2 | 1.0 |
| Ex. 29 | PET-A | 4 | 0.67 | 12.5 | Maleic anhydride-modified PP | 50 | Polyurethane resin | 48 | Epoxy | 2 | 1.0 |
| Ex. 30 | PET-A | 4 | 0.67 | 12.5 | Maleic anhydride-modified PP | 50 | Polyurethane resin | 48 | Epoxy | 2 | 1.0 |
| Ex. 31 | PET-A | 4 | 0.67 | 12.5 | Maleic anhydride-modified PP | 50 | Polyurethane resin | 48 | Epoxy | 2 | 1.0 |
| Ex. 32 | PET-A | 4 | 0.67 | 12.5 | Maleic anhydride-modified PP | 50 | Polyurethane resin | 48 | Epoxy | 2 | 1.0 |
| Ex. 33 | PET-A | 4 | 0.67 | 12.5 | Maleic anhydride-modified PP | 50 | Polyurethane resin | 48 | Epoxy | 2 | 1.0 |
| Ex. 34 | PET-A | 4 | 0.67 | 12.5 | Maleic anhydride-modified PP | 50 | Polyurethane resin | 48 | Epoxy | 2 | 1.0 |
| Ex. 35 | PET-A | 4 | 0.67 | 12.5 | Maleic anhydride-modified PP | 50 | Polyurethane resin | 48 | Epoxy | 2 | 1.0 |
| Ex. 36 | PET-B | 4 | 0.65 | 30 | Maleic anhydride-modified PP | 50 | Polyurethane resin | 48 | Epoxy | 2 | 1.0 |
| Ex. 37 | PET-C | 4 | 0.8 | 20 | Maleic anhydride-modified PP | 50 | Polyurethane resin | 48 | Epoxy | 2 | 1.0 |

(continued)

| | P1 layer | | | | P2 layer | | | | | | W2a/W2b |
|---|---|---|---|---|---|---|---|---|---|---|---|
| | Polyester | Content of TiO$_2$ particles % by wt | IV | Amount of COOH terminal group eq./t | Modified olefin resin | | Main component | | Crosslinking agent | | |
| | | | | | Type | % by wt | Type | % by wt | Type | % by wt | |
| Comp. Ex. 1 | PET-A | 0 | 0.7 | 12 | - | - | - | - | - | - | - |
| Comp. Ex. 2 | PET-A | 0 | 0.7 | 12 | Maleic anhydride-modified PP | 50 | Polyurethane resin | 48 | Epoxy | 2 | 1.0 |
| Comp. Ex. 3 | PET-A | 0 | 0.7 | 12 | - | - | - | - | - | - | - |
| Comp. Ex. 4 | - | - | - | - | - | - | - | - | - | - | - |
| Comp. Ex. 5 | PET-A | 4 | 0.67 | 12.5 | Maleic anhydride-modified PP | 50 | Polyurethane resin | 48 | Epoxy | 2 | 1.0 |
| Comp. Ex. 6 | PET-A | 4 | 0.67 | 12.5 | Maleic anhydride-modified PP | 50 | Polyurethane resin | 48 | Epoxy | 2 | 1.0 |
| Comp. Ex. 7 | PET-A | 4 | 0.67 | 12.5 | Maleic anhydride-modified PP | 50 | Polyurethane resin | 48 | Epoxy | 2 | 1.0 |
| Comp. Ex. 8 | PET-A | 4 | 0.67 | 12.5 | Maleic anhydride-modified PP | 50 | Polyurethane resin | 48 | Epoxy | 2 | 1.0 |
| Comp. Ex. 9 | PET-A | 4 | 0.67 | 12.5 | Maleic anhydride-modified PP | 50 | Polyurethane resin | 48 | Epoxy | 2 | 1.0 |
| Comp. Ex. 10 | PET-A | 4 | 0.67 | 12.5 | Maleic anhydride-modified PP | 50 | Polyurethane resin | 48 | Epoxy | 2 | 1.0 |

[Table 1-2-1]

| | P3 layer | | | | | | Thickness | | | | |
| | P31 layer | | P32 layer | | P33 layer | | TiO$_2$ content in P3 layer | P1 | P2 | P3 | P1/P3 | Total |
| | Composition | % by weight | Composition | % by weight | Composition | % by weight | % by weight | μm | μm | μm | | μm |
|---|---|---|---|---|---|---|---|---|---|---|---|---|
| Ex. 1 | EPBC | 100 | PP/TiO$_2$ | 85/15 | EPC/LLDPE | 80/20 | 5 | 150 | 0.4 | 150 | 1.0 | 300 |
| Ex. 2 | EPBC | 100 | PP/TiO$_2$ | 85/15 | EPC/LLDPE | 80/20 | 5 | 150 | 0.1 | 150 | 1.0 | 300 |
| Ex. 3 | EPBC | 100 | PP/TiO$_2$ | 85/15 | EPC/LLDPE | 80/20 | 5 | 150 | 3 | 150 | 1.0 | 303 |
| Ex. 4 | EPBC | 100 | PP/TiO$_2$ | 85/15 | EPC/LLDPE | 80/20 | 5 | 50 | 0.4 | 250 | 0.2 | 300 |
| Ex. 5 | EPBC | 100 | PP/TiO$_2$ | 85/15 | EPC/LLDPE | 80/20 | 5 | 250 | 0.4 | 50 | 5.0 | 300 |
| Ex. 6 | EPBC | 100 | PP/TiO$_2$ | 85/15 | EPC/LLDPE | 80/20 | 5 | 15 | 0.4 | 15 | 1.0 | 30 |
| Ex. 7 | EPBC | 100 | PP/TiO$_2$ | 85/15 | EPC/LLDPE | 80/20 | 5 | 245 | 0.4 | 245 | 1.0 | 490 |
| Ex. 8 | EPBC | 100 | PP/TiO$_2$ | 85/15 | EPC/LLDPE | 80/20 | 5 | 150 | 0.4 | 150 | 1.0 | 300 |
| Ex. 9 | EPBC | 100 | PP/TiO$_2$ | 85/15 | EPC/LLDPE | 80/20 | 5 | 150 | 0.4 | 150 | 1.0 | 300 |
| Ex. 10 | EPBC | 100 | PP/TiO$_2$ | 85/15 | EPC/LLDPE | 80/20 | 5 | 150 | 0.4 | 150 | 1.0 | 300 |
| Ex. 11 | EPBC | 100 | PP/TiO$_2$ | 85/15 | EPC/LLDPE | 80/20 | 5 | 150 | 0.4 | 150 | 1.0 | 300 |
| Ex. 12 | EPBC | 100 | PP/TiO$_2$ | 85/15 | EPC/LLDPE | 80/20 | 5 | 150 | 0.4 | 150 | 1.0 | 300 |
| Ex. 13 | EPBC | 100 | PP/TiO$_2$ | 85/15 | EPC/LLDPE | 80/20 | 5 | 150 | 0.4 | 150 | 1.0 | 300 |
| Ex. 14 | EPBC | 100 | PP/TiO$_2$ | 85/15 | EPC/LLDPE | 80/20 | 5 | 150 | 0.4 | 150 | 1.0 | 300 |
| Ex. 15 | EPBC | 100 | PP/TiO$_2$ | 85/15 | EPC/LLDPE | 80/20 | 5 | 150 | 0.4 | 150 | 1.0 | 300 |
| Ex. 16 | EPBC | 100 | PP/TiO$_2$ | 85/15 | EPC/LLDPE | 80/20 | 5 | 150 | 0.4 | 150 | 1.0 | 300 |
| Ex. 17 | EPBC | 100 | PP/TiO$_2$ | 85/15 | EPC/LLDPE | 80/20 | 5 | 150 | 0.4 | 150 | 1.0 | 300 |

(continued)

| | P3 layer | | | | | | | Thickness | | | | |
| | P31 layer | | P32 layer | | P33 layer | | TiO$_2$ content in P3 layer | P1 | P2 | P3 | P1/P3 | Total |
| | Composition | % by weight | Composition | % by weight | Composition | % by weight | % by weight | μm | μm | μm | | μm |
|---|---|---|---|---|---|---|---|---|---|---|---|---|
| Ex. 18 | EPBC | 100 | PP/TiO$_2$ | 85/15 | EPC/LLDPE | 80/20 | 5 | 150 | 0.4 | 150 | 1.0 | 300 |
| Ex. 19 | EPC/LLDPE | 80/20 | PP/TiO$_2$ | 85/15 | EPC/LLDPE | 80/20 | 5 | 150 | 0.4 | 150 | 1.0 | 300 |
| Ex. 20 | - | - | EPBC/TiO$_2$ | 87/13 | EPC/LLDPE | 80/20 | 5 | 150 | 0.4 | 150 | 1.0 | 300 |
| Ex. 21 | - | - | EPBC/TiO$_2$ | 90/10 | - | - | 5 | 150 | 0.4 | 150 | 1.0 | 300 |
| Ex. 22 | EPBC/acid modified olefm | 80/20 | PP/TiO$_2$ | 85/15 | EPC/LLDPE | 80/20 | 5 | 150 | 0.4 | 150 | 1.0 | 300 |
| Ex. 23 | EPBC | 100 | PP/TiO$_2$ | 85/15 | EPBC | 100 | 5 | 150 | 0.4 | 150 | 1.0 | 300 |
| Ex. 24 | EPBC/Polyolefin elastomer A | 80/20 | PP/TiO$_2$ | 85/15 | EPC/LLDPE | 80/20 | 5 | 150 | 0.4 | 150 | 1.0 | 300 |

[Table 1-2-2]

| | P3 layer | | | | | | | Thickness | | | | |
| | P31 layer | | P32 layer | | P33 layer | | TiO$_2$ content in P3 layer | P1 | P2 | P3 | P1/P3 | Total |
| | Composition | % by weight | Composition | % by weight | Composition | % by weight | % by weight | μm | μm | μm | | μm |
| Ex. 25 | EPBC | 100 | EPBC/TiO$_2$ | 85/15 | EPC/LLDPE | 80/20 | 5 | 150 | 0.4 | 150 | 1.0 | 300 |
| Ex. 26 | EPBC | 100 | - | - | EPC/LLDPE | 80/20 | 0 | 150 | 0.4 | 150 | 1.0 | 300 |
| Ex. 27 | EPBC | 100 | PP/TiO$_2$ | 99/1 | EPC/LLDPE | 80/20 | 0.5 | 150 | 0.4 | 150 | 1.0 | 300 |
| Ex. 28 | EPBC | 100 | PP/TiO$_2$ | 40/60 | EPC/LLDPE | 80/20 | 20 | 150 | 0.4 | 150 | 1.0 | 300 |
| Ex. 29 | EPBC | 100 | PP/TiO$_2$ | 37/63 | EPC/LLDPE | 80/20 | 21 | 150 | 0.4 | 150 | 1.0 | 300 |
| Ex. 30 | EPBC | 100 | PP/TiO$_2$ | 85/15 | EPC/LLDPE | 80/20 | 5 | 14 | 0.4 | 70 | 0.2 | 84 |
| Ex. 31 | EPBC | 100 | PP/TiO$_2$ | 85/15 | EPC/LLDPE | 80/20 | 5 | 15 | 0.4 | 75 | 0.2 | 90 |
| Ex. 32 | EPBC | 100 | PP/TiO$_2$ | 85/15 | EPC/LLDPE | 80/20 | 5 | 300 | 0.4 | 150 | 2.0 | 450 |
| Ex. 33 | EPBC | 100 | PP/TiO$_2$ | 85/15 | EPC/LLDPE | 80/20 | 5 | 301 | 0.4 | 150 | 2.0 | 451 |
| Ex. 34 | EPBC/Polyolefin elastomer B | 80/20 | PP/TiO$_2$ | 85/15 | EPC/LLDPE | 80/20 | 5 | 150 | 0.4 | 150 | 1.0 | 300 |
| Ex. 35 | EPBC/Polyolefin elastomer B | 80/20 | PP/TiO$_2$ | 85/15 | EPBC/Polyolefin elastomer B | 80/20 | 5 | 150 | 0.4 | 150 | 1.0 | 300 |
| Ex. 36 | EPBC | 100 | PP/TiO$_2$ | 85/15 | EPC/LLDPE | 80/20 | 5 | 150 | 0.4 | 150 | 1.0 | 300 |
| Ex. 37 | EPBC | 100 | PP/TiO$_2$ | 85/15 | EPC/LLDPE | 80/20 | 5 | 150 | 0.4 | 150 | 1.0 | 300 |
| Comp. Ex. 1 | - | - | - | - | - | - | 0 | 300 | 0 | 0 | - | 300 |
| Comp. Ex. 2 | - | - | - | - | - | - | 0 | 300 | 0.4 | 0 | - | 300 |
| Comp. Ex. 3 | EPBC | 100 | - | - | - | - | 0 | 150 | 0 | 150 | 1.0 | 300 |
| Comp. Ex. 4 | EPBC | 100 | - | - | - | - | 0 | 0 | 0 | 300 | 0.0 | 300 |

(continued)

| | P3 layer | | | | | | TiO$_2$ content in P3 layer | Thickness | | | | |
| | P31 layer | | P32 layer | | P33 layer | | | P1 | P2 | P3 | P1/P3 | Total |
| | Composition | % by weight | Composition | % by weight | Composition | % by weight | % by weight | $\mu$m | $\mu$m | $\mu$m | | $\mu$m |
| Comp. Ex. 5 | EPBC | 100 | PP/TiO$_2$ | 85/15 | EPC/LLDPE | 80/20 | 5 | 150 | 0.09 | 150 | 1.0 | 300 |
| Comp. Ex. 6 | EPBC | 100 | PP/TiO$_2$ | 85/15 | EPC/LLDPE | 80/20 | 5 | 150 | 3.1 | 150 | 1.0 | 303 |
| Comp. Ex. 7 | EPBC | 100 | PP/TiO$_2$ | 85/15 | EPC/LLDPE | 80/20 | 5 | 45 | 0.4 | 255 | 0.18 | 300 |
| Comp. Ex. 8 | EPBC | 100 | PP/TiO$_2$ | 85/15 | EPC/LLDPE | 80/20 | 5 | 251 | 0.4 | 49 | 5.1 | 300 |
| Comp. Ex. 9 | EPBC | 100 | PP/TiO$_2$ | 85/15 | EPC/LLDPE | 80/20 | 5 | 14 | 0.4 | 14 | 1.0 | 28 |
| Comp. Ex. 10 | EPBC | 100 | PP/TiO$_2$ | 85/15 | EPC/LLDPE | 80/20 | 5 | 251 | 0.4 | 251 | 1.0 | 502 |

[Table 2-1]

| | Processibility | Average relative reflectance | UV resistance | Partial discharge voltage | Water vapor permeability | Adhesion strength with EVA | | Interlayer adhesion | | Surface flatness (Curl resistance) |
|---|---|---|---|---|---|---|---|---|---|---|
| | | | | | | After wet heat resistance test | Initial | After wet heat resistance test | Initial | |
| Ex. 1 | S | S | S | S | S | S | S | A | S | A |
| Ex. 2 | S | S | S | S | S | S | S | A | B | A |
| Ex. 3 | S | S | S | S | S | S | S | A | B | A |
| Ex. 4 | S | S | S | S | S | S | S | A | S | B |
| Ex. 5 | S | S | S | S | B | S | S | A | S | A |
| Ex. 6 | S | S | S | B | C | S | S | A | S | A |
| Ex. 7 | B | S | S | S | S | S | S | A | S | A |
| Ex. 8 | S | S | S | S | S | S | S | A | S | A |
| Ex. 9 | S | S | S | S | S | S | S | A | S | A |
| Ex. 10 | S | S | C | S | S | S | S | A | S | A |
| Ex. 11 | S | S | B | S | S | S | S | A | S | A |
| Ex. 12 | S | S | S | S | S | S | S | A | A | A |
| Ex. 13 | S | S | S | S | S | S | S | A | B | A |
| Ex. 14 | S | S | S | S | S | S | S | A | B | A |

| | Surface flatness (Curl resistance) | Interlayer adhesion | | Adhesion strength with EVA | | Water vapor permeability | Partial discharge voltage | UV resistance | Average relative reflectance | Processibility |
|---|---|---|---|---|---|---|---|---|---|---|
| | | Initial | After wet heat resistance test | Initial | After wet heat resistance test | | | | | |
| Ex. 15 | A | A | A | S | S | S | S | S | S | S |
| Ex. 16 | A | S | B | S | S | S | S | S | S | S |
| Ex. 17 | A | A | A | S | S | S | S | S | S | S |
| Ex. 18 | A | B | A | S | s | S | S | S | S | S |
| Ex. 19 | A | A | A | S | S | S | S | S | S | S |
| Ex. 20 | A | B | A | A | A | S | S | S | S | S |
| Ex. 21 | A | B | A | A | A | S | S | S | S | S |
| Ex. 22 | A | S | A | S | S | S | S | S | S | S |
| Ex. 23 | A | S | A | S | S | S | S | S | S | S |
| Ex. 24 | A | S | S | S | S | S | S | S | S | S |

EP 2 743 081 A1

35

[Table 2-2]

| | Surface flatness (Curl resistance) | Interlayer adhesion | | Adhesion strength with EVA | | Water vapor permeability | Partial discharge voltage | UV resistance | Average relative reflectance | Processibility |
|---|---|---|---|---|---|---|---|---|---|---|
| | | Initial | After wet heat resistance test | Initial | After wet heat resistance test | | | | | |
| Ex. 25 | S | S | A | S | S | S | S | S | S | S |
| Ex. 26 | A | S | A | S | S | S | S | S | A | S |
| Ex. 27 | A | S | A | S | S | S | S | S | A | S |
| Ex. 28 | A | S | A | A | A | S | S | S | S | S |
| Ex. 29 | A | S | A | B | B | S | S | S | S | S |
| Ex. 30 | B | S | A | S | S | B | B | S | A | S |
| Ex. 31 | B | S | A | S | S | A | B | S | A | S |
| Ex. 32 | A | S | A | S | S | S | S | S | S | A |
| Ex. 33 | A | S | A | S | S | S | S | S | S | B |
| Ex. 34 | A | S | S | S | S | S | S | S | S | S |
| Ex. 35 | A | S | S | S | SS | S | S | S | S | S |
| Ex. 36 | A | S | D | S | D | S | S | S | S | S |
| Ex. 37 | A | A | A | S | S | S | S | S | S | S |
| Comp. Ex. 1 | A | - | - | C | C | C | S | C | C | S |
| Comp. Ex. 2 | A | - | - | C | C | C | S | C | C | S |
| Comp. Ex. 3 | A | C | C | S | S | S | S | C | C | S |
| Comp. Ex. 4 | A | S | A | S | S | S | S | C | C | S |
| Comp. Ex. 5 | A | C | A | S | S | S | S | S | S | S |
| Comp. Ex. 6 | A | C | A | S | S | S | S | S | S | S |

EP 2 743 081 A1

36

(continued)

| | Surface flatness (Curl resistance) | Interlayer adhesion | | Adhesion strength with EVA | | Water vapor permeability | Partial discharge voltage | UV resistance | Average relative reflectance | Processibility |
|---|---|---|---|---|---|---|---|---|---|---|
| | | Initial | After wet heat resistance test | Initial | After wet heat resistance test | | | | | |
| Comp. Ex. 7 | C | S | A | S | S | S | S | S | S | S |
| Comp. Ex. 8 | A | S | A | S | S | C | S | S | S | S |
| Comp. Ex. 9 | A | S | A | S | S | C | C | S | S | S |
| Comp. Ex. 10 | A | S | A | S | S | S | S | S | S | C |

[Explanation of numerals]

1: backsheet
2: sealant
3: photovoltatic element
4: transparent substrate
5: surface of the solar cell backsheet on the side of the sealant 2
6: surface of the solar cell backsheet opposite to the side of the sealant 2

**Claims**

1.  A laminate sheet comprising a layer containing a polyester resin as its main component (P1 layer), an adhesive resin layer (P2 layer), and a layer containing a polyolefin resin as its main component (P3 layer), wherein the laminate sheet has a total thickness of at least 30 $\mu$m and up to 500 $\mu$m, the P2 layer has a thickness of at least 0.1 $\mu$m and up to 3 $\mu$m, and ratio of the thickness of the P1 layer (P1) to the thickness of the P3 layer (P3) (ratio P1/P3) is at least 0.2 and up to 5.

2.  A laminate sheet according to claim 1 wherein the P2 layer comprises a modified polyolefin resin.

3.  A laminate sheet according to claim 2 wherein the P2 layer contains a polyurethane resin, and ratio of content W2a of the modified polyolefin resin of the P2 layer to content W2b of the polyurethane resin (ratio W2a/W2b) is at least 0.1 and up to 9.

4.  A laminate sheet according to any one of claims 1 to 3 wherein the P3 layer has a thickness of at least 75 $\mu$m.

5.  A laminate sheet according to any one of claims 1 to 4 wherein the P3 layer has a laminate structure.

6.  A laminate sheet according to any one of claims 1 to 5 wherein the P3 layer contains at least 5% by weight and up to 50% by weight of a polyolefin elastomer.

7.  A laminate sheet according to any one of claims 1 to 6 wherein the P3 layer contains a modified polyolefin resin.

8.  A laminate sheet according to any one of claims 1 to 7 wherein the P1 layer contains at least 1% by weight and up to 30% by weight of titanium oxide particles, and/or the P3 layer contains at least 0.5% by weight and up to 20% by weight of the titanium oxide particles

9.  A laminate sheet according to any one of claims 1 to 8 wherein the polyester resin of the P1 layer is polyethylene terephthalate, the P1 layer has an intrinsic viscosity IV of at least 0.65 and up to 0.80, and content of the COOH terminal group is up to 25 eq./t.

10. A method for producing the laminate sheet of any one of claims 1 to 9 comprising the step of providing the P3 layer by melt extrusion lamination on a sheet having the P2 layer having a thickness of up to 3 $\mu$m on at least one surface of the P1 layer.

11. A method for producing a laminate sheet according to claim 10 comprising the step of
    preparing a sheet of a resin composition for the P1 layer,
    coating a coating composition containing a resin composition for the P2 layer on at least one surface of the sheet after optional uniaxial stretching of the sheet, and at least
    uniaxially stretching the coated sheet.

12. A solar cell backsheet using the laminate sheet according to any one of claims 1 to 9.

13. A solar cell using the solar cell backsheet of claim 12.

Figure 1

## INTERNATIONAL SEARCH REPORT

| International application No. |
| --- |
| PCT/JP2012/069440 |

A.  CLASSIFICATION OF SUBJECT MATTER
*B32B27/32*(2006.01)i

According to International Patent Classification (IPC) or to both national classification and IPC

B.  FIELDS SEARCHED

Minimum documentation searched (classification system followed by classification symbols)
B32B1/00-43/00, H01L31/04-31/078, 51/42-51/48

Documentation searched other than minimum documentation to the extent that such documents are included in the fields searched
Jitsuyo Shinan Koho          1922–1996   Jitsuyo Shinan Toroku Koho   1996–2012
Kokai Jitsuyo Shinan Koho    1971–2012   Toroku Jitsuyo Shinan Koho   1994–2012

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
| --- | --- | --- |
| X<br>A | JP 2008-30792 A  (Toyobo Co., Ltd.),<br>14 February 2008 (14.02.2008),<br>paragraphs [0052] to [0054]<br>(Family: none) | 1,10<br>2-9,11-13 |
| X<br>A | JP 2005-280111 A  (Mitsubishi Plastics, Inc.),<br>13 October 2005 (13.10.2005),<br>paragraph [0059]<br>(Family: none) | 1<br>2-13 |
| X<br>A | JP 2004-275046 A  (Toppan Printing Co., Ltd.),<br>07 October 2004 (07.10.2004),<br>paragraph [0048]<br>(Family: none) | 1<br>2-13 |

| ☒ | Further documents are listed in the continuation of Box C. | ☐ | See patent family annex. |

| * | Special categories of cited documents: |
| --- | --- |
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
| --- | --- |
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>    24 October, 2012 (24.10.12) | Date of mailing of the international search report<br>    06 November, 2012 (06.11.12) |
| --- | --- |
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2012/069440

C (Continuation).    DOCUMENTS CONSIDERED TO BE RELEVANT

| Category* | Citation of document, with indication, where appropriate, of the relevant passages | Relevant to claim No. |
|---|---|---|
| A | WO 2011/030745 A1 (Toray Industries, Inc.), 17 March 2011 (17.03.2011), paragraphs [0001], [0030] to [0031], [0035], [0056] to [0057], [0087] & JP 4849189 B          & JP 2012-81759 A & EP 2476552 A1          & CN 102470653 A & KR 10-2012-0034131 A | 1-13 |

Form PCT/ISA/210 (continuation of second sheet) (July 2009)

**REFERENCES CITED IN THE DESCRIPTION**

**Patent documents cited in the description**

- JP 4217935 B

- JP 2009267294 A

**Non-patent literature cited in the description**

- **M.J. MAULICE ; F. HUIZINGA.** *Anal.Chim.Acta,* 1960, vol. 22, 363